# EUROPEAN PATENT SPECIFICATION

(11) **EP 4 761 037 B1**
(45) Date of publication and mention of the grant of the patent: **09.12.2026**
(21) Application number: 24220282.8
(22) Date of filing: 16.12.2024
(51) Int. Cl.: H02J 7/00

(54) **A CONTROL SYSTEM AND A METHOD FOR VOLTAGE BALANCING OF AN ENERGY STORAGE SYSTEM**
STEUERUNGSSYSTEM UND VERFAHREN ZUM SPANNUNGSAUSGLEICH EINES ENERGIESPEICHERSYSTEMS
SYSTÈME DE COMMANDE ET PROCÉDÉ D'ÉQUILIBRAGE DE TENSION D'UN SYSTÈME DE STOCKAGE D'ÉNERGIE

(43) Date of publication of application: 17.06.2026
(73) Proprietor: Skeleton Technologies GmbH, 04420 Markranstädt (DE)
(72) Inventor: TRUMMAL, Tarmo, 11415 Tallinn (EE)
(74) Representative: Väänänen, Janne Kalervo

(56) References cited:
- US-A1- 2013 106 360
- US-A1- 2016 141 894

## Description

### Field

The invention relates generally to energy storage systems. More particularly, the invention relates to a control system for voltage balancing of an energy storage system. Furthermore, the invention relates to a method and to a computer program for voltage balancing of an energy storage system.

### Background

Large direct "DC" voltage energy storage systems comprise typically strings of series connected energy storage cells each of which can be, for example, a super-capacitor cell such as a carbon capacitor cell or an electric double layer capacitor "EDLC" cell. An energy storage system of the kind mentioned above can be used for example in a static reactive power compensator in which the energy storage system is connected to an alternating "AC" voltage network with a network inverter capable of supplying and drawing reactive power to or from the AC voltage network, and thus the static reactive power compensator mimics an unloaded synchronous machine whose excitation current is controlled to control reactive power produced or consumed by the synchronous machine. With modern super capacitors, the storage capacity of an energy storage system of a static reactive power compensator can be so high and thereby the energy stored by the energy storage system can be so high that the static reactive power compensator can also be used for supporting active power balance of an AC voltage network for a short period of time. Thus, with modern super capacitors, a static reactive power compensator can be provided with functionality for active power control, too.

In addition to static reactive power compensators, large DC voltage energy storage systems can be used in other applications, too. Static reactive power compensators, with possible active power control functionality, represent however a challenging application of super-capacitors because a super-capacitor system of a static reactive power compensator operates in a narrow voltage window. Furthermore, the number of super-capacitor cells in series must be high to achieve a required direct voltage level, and leakage currents are quite high in the super-capacitor cells compared to their capacity, and the super-capacitor cells have an almost linear open circuit voltage "OCV" curve. This means that cell voltages of the series connected super-capacitor cells may diverge quite quickly from each other. Therefore, there is a need for voltage balancing between the super-capacitor cells.

Publication US10978885 describes an apparatus for balancing voltages of capacitor cells in a series string of modules having the capacitor cells. The apparatus comprises a processing system configured to receive an average cell voltage value from each module. The processing system is further configured to determine an overall average cell voltage for all the cells. Furthermore, the processing system is configured to cause each of the modules to determine a relative capacitance for each of its cells and cause each of the modules to balance its capacitor cells based on the respective relative capacitances. An inconvenience related to the apparatus described in US10978885 is that a computation load of the processing system increases along with the total number of the capacitor cells and thus it may be challenging to scale the apparatus described in US10978885 to very large energy storage systems which may comprise thousands, or even tens of thousands, of capacitor cells.

Publication US2016141894 describes an electrical energy storage unit and control system. The electrical energy storage unit comprises a battery system controller and battery packs. Each battery pack has battery cells, a battery pack controller that monitors the cells, a battery pack cell balancer that adjusts the amount of energy stored in the cells, and a battery pack charger. The battery pack controller operates the battery pack cell balancer and the battery pack charger to control the state-of-charge of the cells. The cells can be e.g. lithium-ion battery cells.

Publication US2013106360 describes a system for charge-balancing across one or more modules or cells of a large battery system. The system monitors a voltage output of the one or more modules of the battery system during recharging of the modules and compares measured voltages to a set cutoff voltage. When one or more of the modules meets or exceeds the cutoff voltage, the system activates an energy dissipating device associated with the one or more modules that meets or exceeds the cutoff voltage to reduce the voltage output from those modules below the cutoff voltage before the recharging signal is reapplied to the modules. Through multiple iterations of monitoring, charging, and reducing the energy from the modules above the target, the state-of-charge of each module becomes balanced near or at the cutoff voltage.

### Summary

The following presents a simplified summary to provide basic understanding of some aspects of various embodiments. The summary is not an extensive overview of the invention. It is neither intended to identify key or critical elements of the invention nor to delineate the scope of the invention. The following summary merely presents some concepts in a simplified form as a prelude to a more detailed description of exemplifying and non-limiting embodiments.

In accordance with the invention, there is provided a new control system for voltage balancing of an energy storage system that comprises a string of series connected energy storage racks each of which comprises series connected energy storage modules each comprising one or more energy storage cells. Each of the energy storage cells is connected to a controllable discharge circuit for discharging the energy storage cell under consideration. Each of the above-mentioned energy storage modules can be a single energy storage cell, a parallel connection of two or more energy storage cells, a series connection of two or more energy storage cells, or a combination of energy storage cells connected to each other in another way. Each energy storage cell can be, for example, a capacitor cell or a hybrid energy storage cell. A capacitor cell can be for example a foil capacitor cell, an electrolytic capacitor cell, or a super-capacitor cell such as a carbon capacitor cell or an electric double layer capacitor "EDLC" cell. The hybrid energy storage cell can be considered an energy storage device that comprises active materials with a predominately faradaic charge storage mechanism, i.e. metal oxides, phosphates or graphite, so classical battery active materials, but which also comprises predominately capacitive charge storage mechanisms. Each controllable discharge circuit may comprise, for example, a series connection of a dissipation resistor and a switch so that this series connection is in parallel with one or more energy storage cells to be controlled by the controllable discharge circuit. The switch can be e.g. a metal oxide semiconductor field-effect transistor "MOSFET" or some other suitable switch component.

The control system according to the invention comprises a data processing system configured to:
- determine, based on rack status values, e.g. voltages or states of charge "SoC", of the energy storage racks, which one or ones of the energy storage racks is/are to be controlled to modify respective one or ones of the rack status values to reduce voltage imbalance between the energy storage racks, the rack status values being directly, but not necessarily linearly, proportional to the voltages of the energy storage racks, and
- form a rack reference value, e.g. a voltage or SoC reference, for at least each of the energy storage racks determined to be controlled to modify its rack status value.

Furthermore, the data processing system is configured to carry out the following actions for each of the energy storage racks:
- in response to a situation in which the energy storage rack is to be controlled to modify its rack status value, determining, based on at least i) module status values e.g. voltages or states of charge of the energy storage modules of the energy storage rack and ii) the rack reference value of the energy storage rack, which one or ones of these energy storage modules is/are to be controlled to reduce voltage imbalance between these energy storage modules and to drive the rack status value of the energy storage rack towards the rack reference value of the energy storage rack, and otherwise determining, based on at least these module status values, which one or ones of the energy storage modules belonging to the energy storage rack is/are to be controlled to reduce voltage imbalance between these energy storage modules, and
- controlling the controllable discharge circuits to discharge the one or more energy storage cells belonging to the one or ones of the energy storage modules determined to be controlled.

The data processing system is further configured to form, for each of the energy storage racks to be controlled to modify its rack status value, an offset as a decreasing function of the rack status value of the energy storage rack and to form, for each of the energy storage racks to be controlled to modify its rack status value, the rack reference value as a sum of the offset and a smallest one of the rack status values of the energy storage racks.

In the above-described control system according to the invention, the balancing is carried out in a hierarchical way so that an upper level of the balancing controls the voltage balance of the series connected energy storage racks and a lower level of the balancing controls the voltage balance of the series connected energy storage modules, i.e. capacitor modules or cells, within each energy storage rack based on the rack reference value, e.g. a reference of the voltage or SoC of the rack under consideration. Due to the hierarchical approach, the control system according to the invention is scalable to very large energy storage systems which may comprise thousands, or even tens of thousands, of energy storage cells. In conjunction with very large energy storage systems, the number of hierarchy levels can be greater than two. The data processing system may comprise, for example, many processors so that one of the processors constitutes a string controller for balancing the voltages of the series connected energy storage racks and the other ones of processors constitute rack-specific rack controllers for balancing, within each energy storage rack, the voltages of the series connected energy storage modules and for driving, if needed, the rack status value of the energy storage rack, e.g. the voltage or the SoC of the energy storage rack, towards the respective rack reference value. It is, however, also possible that the functionalities of the above-mentioned string controller and the rack-specific rack controllers are implemented with common hardware as logically separate functional entities.

In accordance with the invention, there is also provided a new method for voltage balancing of an energy storage system that comprises a string of series connected energy storage racks each of which comprises series connected energy storage modules each comprising one or more energy storage cells each being connected to a controllable discharge circuit for discharging the energy storage cell. The method according to the invention comprises:
- determining, based on rack status values of the energy storage racks, which one or ones of the energy storage racks is/are to be controlled to modify respective one or ones of the rack status values to reduce voltage imbalance between the energy storage racks, the rack status values being directly proportional to voltages of the energy storage racks, and
- forming a rack reference value for at least each of the energy storage racks determined to be controlled to modify its rack status value.

Furthermore, the method comprises for each of the energy storage racks:
- in response to a situation in which the energy storage rack is to be controlled to modify its rack status value, determining, based on at least i) module status values of the energy storage modules of the energy storage rack and ii) the rack reference value of the energy storage rack, which one or ones of these energy storage modules is/are to be controlled to reduce voltage imbalance between these energy storage modules and to drive the rack status value of the energy storage rack towards the rack reference value of the energy storage rack, and otherwise determining based on these module status values, which one or ones of the energy storage modules belonging to the energy storage rack is/are to be controlled to reduce voltage imbalance between these energy storage modules, and
- controlling the controllable discharge circuits to discharge the one or more energy storage cells belonging to the one or ones of the energy storage modules determined to be controlled.

The method further comprises forming, for each of the energy storage racks to be controlled to modify its rack status value, an offset as a decreasing function of the rack status value of the energy storage rack and forming, for each of the energy storage racks to be controlled to modify its rack status value, the rack reference value as a sum of the offset and a smallest one of the rack status values of the energy storage racks.

Various embodiments of the invention can be computer implemented invention "CII" embodiments. Therefore, in accordance with the invention, there is also provided a new computer program for voltage balancing of an energy storage system of the kind mentioned above. The computer program according to the invention comprises computer executable instructions for controlling a programmable data processing system to:
- determine, based on rack status values of the energy storage racks, which one or ones of the energy storage racks is/are to be controlled to modify respective one or ones of the rack status values to reduce voltage imbalance between the energy storage racks, the rack status values being directly proportional to voltages of the energy storage racks, and
- form a rack reference value for at least each of the energy storage racks determined to be controlled to modify its rack status value.

The computer program according to the invention further comprises computer executable instructions for controlling the programmable data processing system to carry out the following actions for each of the energy storage racks:
- in response to a situation in which the energy storage rack is to be controlled to modify its rack status value, determining, based on at least i) module status values of the energy storage modules of the energy storage rack and ii) the rack reference value of the energy storage rack, which one or ones of these energy storage modules is/are to be controlled to reduce voltage imbalance between these energy storage modules and to drive the rack status value of the energy storage rack towards the rack reference value of the energy storage rack, and otherwise determining, based on at least these module status values, which one or ones of the energy storage modules belonging to the energy storage rack is/are to be controlled to reduce voltage imbalance between these energy storage modules, and
- control the controllable discharge circuits to discharge the one or more energy storage cells belonging to the one or ones of the energy storage modules determined to be controlled.

Furthermore, the computer program comprises computer executable instructions for controlling the programmable data processing system to form, for each of the energy storage racks to be controlled to modify its rack status value, an offset as a decreasing function of the rack status value of the energy storage rack and to form for each of the energy storage racks to be controlled to modify its rack status value, the rack reference value as a sum of the offset and a smallest one of the rack status values of the energy storage racks.

In accordance with the invention, there is also provided a new computer program product. The computer program product comprises a non-volatile computer readable medium, e.g. an electrically erasable programmable read-only memory "EEPROM", a universal serial bus "USB" memory, or a compact disc "CD", encoded with a computer program according to the invention.

Exemplifying and non-limiting embodiments are described in accompanied dependent claims.

Various exemplifying and non-limiting embodiments both as to constructions and to methods of operation, together with additional objects and advantages thereof, will be best understood from the following description of specific exemplifying and non-limiting embodiments when read in conjunction with the accompanying drawings.

The verbs "to comprise" and "to include" are used in this document as open limitations that neither exclude nor require the existence of unrecited features.

The features recited in dependent claims are mutually freely combinable unless otherwise explicitly stated.

Furthermore, it is to be understood that the use of "a" or "an", i.e. a singular form, throughout this document does not exclude a plurality.

### Brief description of the figures

Exemplifying and non-limiting embodiments and their advantages are explained in greater detail below in the sense of examples and with reference to the accompanying drawings, in which:
Figure 1 illustrates a control system according to an exemplifying and non-limiting embodiment for voltage balancing of an energy storage system,
Figure 2a illustrates a control system according to an exemplifying and non-limiting embodiment for voltage balancing of an energy storage system,
Figures 2b and 2c demonstrate a functionality of the control system illustrated in figure 2a in an exemplifying operating situation, and
Figure 3 shows a flowchart of a method according to an exemplifying and non-limiting embodiment for voltage balancing of an energy storage system.

### Description of the exemplifying embodiments

The specific examples provided in the description given below should not be construed as limiting the scope and/or the applicability of the invention. Lists and groups of examples provided in the description given below are not exhaustive unless otherwise explicitly stated.

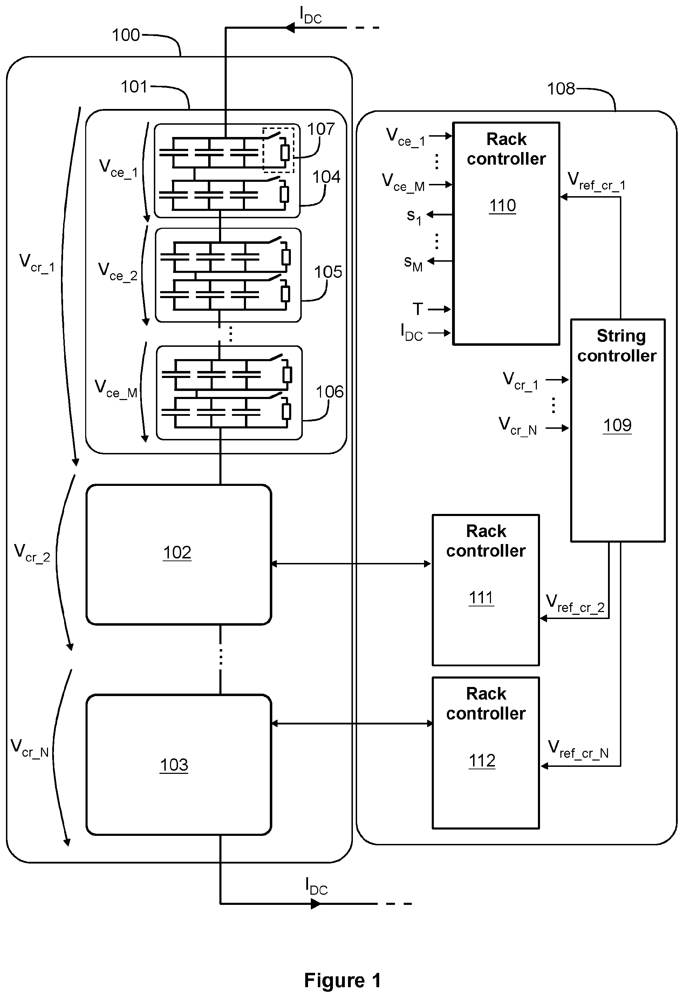

Figure 1 illustrates a control system according to an exemplifying and non-limiting embodiment for voltage balancing of an energy storage system 100. An electric circuitry for charging and discharging the energy storage system 100 is not shown in figure 1. The energy storage system 100 comprises a string of series connected energy storage racks. In this exemplifying case, the number of the series connected energy storage racks is N. In figure 1, three of the energy storage racks are denoted with references 101, 102, and 103. Each of the energy storage racks comprises series connected energy storage modules. In this exemplifying case, the number of the series connected energy storage modules within the energy storage rack 101 is M. In figure 1, three of the energy storage modules of the energy storage rack 101 are denoted with references 104, 105, and 106. Each of the energy storage modules comprises one or more energy storage cells each of which is connected to a controllable discharge circuit. Each energy storage cell can be, for example, a capacitor cell or a hybrid energy storage cell. A capacitor cell can be for example a foil capacitor cell, an electrolytic capacitor cell, or a super-capacitor cell such as a carbon capacitor cell or an electric double layer capacitor "EDLC" cell. The hybrid energy storage cell can be considered an energy storage device that comprises active materials with a predominately faradaic charge storage mechanism, i.e. metal oxides, phosphates or graphite, so classical battery active materials, but which also comprises predominately capacitive charge storage mechanisms, i.e. porous carbons with surface area above 500 m²/g, preferably above 1000 m²/g, as they are used in supercapacitors. The resulting hybrid energy storage cell can exhibit a nonlinear relationship between stored charge and voltage, so for example a voltage plateau as it is the case in batteries and therefore in such an embodiment the stored energy in the hybrid energy storage device would not be proportional to the square of the voltage. More information about hybrid energy storage cells can be found e.g. https://www.skeletontech.com/superbattery. Each controllable discharge circuit may comprise, for example, a series connection of a dissipation resistor and a switch so that this series connection is in parallel with one or more energy storage cells to be controlled by the controllable discharge circuit. The switch can be e.g. a metal oxide semiconductor field-effect transistor "MOSFET" or some other controllable switch component.

In exemplifying cases where an energy storage module of the kind mentioned above comprises many energy storage cells, the energy storage cells can be connected in series, in parallel, or in another way to each other. For example, there can be a series connection of a groups of parallel connected energy storage cells or a parallel connection of groups of series connected energy storage cells. In the exemplifying case shown in figure 1, each energy storage module comprises a series connection of groups of parallel connected energy storage cells and each of the groups of parallel connected energy storage cells is provided with one of the above-mentioned controllable discharge circuits. In figure 1, one of the controllable discharge circuits is denoted with a reference 107.

The control system comprises a data processing system 108. In this exemplifying case, the data processing system 108 comprises a first processor that constitutes a string controller 109 and second processors each of which constitutes one of rack-specific rack controllers. In figure 1, three of the rack controllers are denoted with references 110, 111, and 112. It is, however, also possible that functionalities of the string controller 109 and the rack controllers are implemented with common hardware as logically separate functional entities. Thus, the invention is not limited to any specific implementation architectures of the data processing system 108.

The above-mentioned string controller 109 is configured to determine, based on rack status values of the energy storage racks, which one or ones of the energy storage racks is/are to be controlled to modify the respective rack status value or values to reduce voltage imbalance between the energy storage racks. The rack status values of the energy storage racks can be for example voltages of the energy storage racks or other quantities directly, but not necessarily linearly, proportional to the voltages of the energy storage racks, e.g. states of charge "SoC" of the energy storage racks. The voltages can be expressed as volts or as proportional units "pu" so that 1 or 100% means the nominal voltage of the energy storage rack under consideration. The state of charge can be expressed in e.g. ampere-seconds or as a proportional unit "pu" so that 1 or 100% means the nominal state of charge of the energy storage rack under consideration. A benefit of using proportional units is that computations can be simpler in cases where the number of series connected energy storage modules, e.g. capacitor modules or energy storage cells, is different in different ones of the energy storage racks since, in conjunction with different energy storage racks, the 1 pu and 100% may mean different voltages in volts. A situation in which there are different number of series connected energy storage modules in different ones of energy storage racks may happen for example in static reactive power compensators with active power control functionality, as failed energy storage modules will be taken out of operation by bypassing them.

In the exemplifying case shown in figure 1, the rack status values of the energy storage racks are the voltages V_{cr_1}, V_{cr_2}, ..., V_{cr_N} of the energy storage racks. Furthermore, the string controller 109 is configured to form a rack reference value for at least each of the energy storage racks which has/have been determined to be controlled to modify its rack status value. The rack reference value can be for example a reference value of the voltage or the state of charge "SoC" of the energy storage rack under consideration. In the exemplifying case shown in figure 1, the rack reference values are voltage references V_{ref_cr_1}, V _{ref_cr_2}, ..., V _{ref_cr_N} of the energy storage racks. Each of the rack reference values can also be used as a flag variable which indicates whether, or not, a respective energy storage rack is to be controlled to modify its rack status value for example so that the rack reference is set to have a predetermined flag value, e.g. zero, when the respective energy storage rack does not need to be controlled to modify its rack status value - the energy storage rack may, however, need to be controlled because of possible internal voltage imbalance between its energy storage modules even if its rack status value, e.g. rack voltage or SoC, is satisfactory.

Each of the rack controllers is configured to determine, in response to a situation in which the respective energy storage rack is to be controlled to modify its rack status value, and based on at least i) module status values of the energy storage modules of the energy storage rack and ii) the rack reference value of the energy storage rack, which one or ones of these energy storage modules is/are to be controlled by the respective one or more controllable discharge circuits to reduce voltage imbalance between these energy storage modules and to drive the rack status value of the energy storage rack towards the rack reference value of the energy storage rack. The module status values of the energy storage modules can be for example voltages of the energy storage modules or other quantities directly, but not necessarily linearly, proportional to the voltages of the energy storage modules, e.g. states of charge "SoC" of the energy storage modules. The voltages can be expressed as volts or as proportional units "pu" so that 1 or 100% means the nominal voltage of the energy storage module under consideration. The state of charge can be expressed in e.g. ampere-seconds or as proportional units "pu" so that 1 or 100% means the nominal state of charge of the energy storage module under consideration. In the exemplifying case shown in figure 1, the module status values of the energy storage modules are the voltages of the energy storage modules. In figure 1, the voltages of the energy storage modules 104, 105, and 106 are marked as V_{ce_1}, V_{ce_2}, and V_{ce_M}.

Each of the rack controllers is configured to determine, in response to a situation in which the respective energy storage rack does not need to be controlled to modify its rack status value, and based on at least the module status values of the energy storage modules of the energy storage rack under consideration, which one or ones of the energy storage modules belonging to the energy storage rack is/are to be controlled by the respective one or more controllable discharge circuits to reduce voltage imbalance between these energy storage modules. Thus, even if the string controller 109 did not indicate a need to change the rack status value, e.g. the voltage or SoC of the energy storage rack, there can still be a need for balancing inside the energy storage rack due to imbalance between the energy storage modules belonging to the energy storage rack.

Each of the rack controllers is configured to control appropriate one or ones of the controllable discharge circuits to discharge one or more energy storage cells which belong to the one or more energy storage modules which has/have been determined to be controlled. For example, in an exemplifying situation where a relative portion of the voltage V_{ce_1} of the energy storage module 104 on the voltage V_{cr_1} of the energy storage rack 101 needs to be lowered, the rack controller 110 sets the switches, e.g. MOSFETs, of the controllable discharge circuits of the energy storage module 104 into a conductive state. It is however also possible that each module that comprises one or more of the energy storage modules is provided with a controller which controls the switches of the controllable discharge circuits in accordance with instructions received from the rack controller 110, or there can be a master controller in each energy storage rack which controls the switches of the controllable discharge circuits in accordance with instructions received from the rack controller 110. It is to be noted that the invention is not limited to any specific implementation architectures.

In figure 1, signals s₁, ..., s_{M} depict the signals for controlling the controllable discharge circuits of the energy storage module 104. A discharge time, i.e. the time how long the switches of the controllable discharge circuits are conductive during each discharging period, can be e.g. a settable parameter. It is to be noted that depending on supply current I_{DC} and on the dissipation resistors of the controllable discharge circuits, voltage of an energy storage module can even rise also in a situation in which its controllable discharge circuit or circuits is/are active, but this voltage rises slower than voltage of a corresponding other energy storage module whose controllable discharge circuit or circuits is/are not active, and thus the difference between these voltages changes and thereby the ratio of these voltages can be controlled with the aid of the respective controllable discharge circuits. Furthermore, the controllable discharge circuits can be controlled based on e.g. temperature and/or electric current measurements of the energy storage cells.

There are different ways to determine which one or ones of the energy storage racks, if any, are to be controlled to modify its rack status value. Correspondingly, there are different ways to form the rack reference values for the energy storage racks whose rack status values are to be modified. Some examples are presented below. The invention is not, however, limited to any of the below-presented examples.

### Example 1a of determining the energy storage racks to be controlled:

In a control system according to an exemplifying and non-limiting embodiment, the string controller 109 is configured to compute, for each of the energy storage racks, a string balancing coefficient according to the following formula: ${C}_{bs_i} = \left({S}_{cr_i}-{minS}_{cr}\right) / \left({maxS}_{cr}-{minS}_{cr}\right) ,$ (1) where C_{bs_i} is the string balancing coefficient of i^{th} one of the energy storage racks 1... N, S_{cr_i} is the rack status value, i.e. in this case the voltage V_{cr_i}, of the i^{th} one of the energy storage racks, minS_{cr} is the smallest one of the rack status values, i.e. in this case the smallest one of the voltages V_{cr_1}, V_{cr_2}, ..., V_{cr_N} of the energy storage racks, and maxS_{cr} is the greatest one of the rack status values of the energy storage racks, i.e. in this case the greatest one of the voltages V_{cr_1}, V_{cr_2}, ..., V_{cr_N} of the energy storage racks. The string controller 109 is configured to determine each of the energy storage racks, whose string balancing coefficient exceeds a first predetermined limit e.g. 0.95, to be controlled to modify its rack status value.

### Example 1b of determining the energy storage racks to be controlled:

In a control system according to an exemplifying and non-limiting embodiment, the string controller 109 is configured to determine each of the energy storage racks, whose rack status value, e.g. the voltage V_{cr_i} or SoC, exceeds a predetermined minimum balancing value e.g. a predetermined minimum balancing voltage, to be controlled to modify its rack status value.

### Example 2a of forming the rack reference values:

In a control system according to an exemplifying and non-limiting embodiment, the string controller 109 is configured to form, for each of the energy storage racks to be controlled to modify its rack status value, an offset as a decreasing function of the rack status value of the energy storage rack and to form, for each of the energy storage racks to be controlled to modify its rack status value, the rack reference value as a sum of the offset and the smallest one of the rack status values of the energy storage racks. In an exemplifying case where the rack status values are the voltages V_{cr_1}, V_{cr_2}, ..., V_{cr_N} of the energy storage racks, the offset of the i^{th} energy storage rack is a voltage offset V_{cr_off_i} and thus the above-mentioned rack reference value V_{ref_cr_i} is the sum V_{cr_off_i} + minV_{cr}, where minV_{cr} is the smallest one of the voltages V_{cr_1}, V_{cr_2}, ..., V_{cr_N}. This approach can be completed with a condition that the energy storage rack under consideration is controlled to modify its rack status value only if the offset formed for the energy storage rack under consideration is less than a difference between the greatest one of the rack status values of the energy storage racks and the smallest one of the rack status values. In an exemplifying case where the rack status values are the voltages V_{cr_1}, V_{cr_2}, ..., V_{cr_N} of the energy storage racks, the i^{th} one of energy storage racks is controlled to modify its voltage V_{cr_i} only if V_{cr_off_i} < maxV_{cr} - minV_{cr}.

### Example 2b of forming the rack reference values:

In a control system according to an exemplifying and non-limiting embodiment, the string controller 109 is configured to compute, for each of the energy storage racks whose rack status value exceeds the predetermined minimum balancing value, the rack reference value according to the following formula: ${R}_{ref_i} = {S}_{set} - \left({C}_{min}/{C}_{i}\right) \left({S}_{set}-{S}_{min_C}\right) ,$ (2) where R_{ref_i} is the rack reference value, e.g. the voltage reference V_{ref_cr_i} or a SoC reference, for i^{th} one of the energy storage racks, Cᵢ is an estimate of capacitance of the i^{th} one of the energy storage racks, Cₘᵢₙ is the smallest one of the estimates of the capacitances of the energy storage racks, is S_{min_C} is the rack status value, e.g. the voltage, of the energy storage rack having the smallest capacitance Cₘᵢₙ, and Sₛₑₜ is a set point value, e.g. a voltage set point or a SoC set point, such that the imbalance between the energy storage racks is minimized when the rack status values of the energy storage racks have the set point value. The estimates C₁, C₂, ..., C_{N} of the capacitances of the energy storage racks can be obtained for example based measured voltages and currents of the energy storage racks. For example, a series of voltage and current measurements observed over time can be used with e.g. Kalman filtering to obtain the estimates C₁, C₂, ..., C_{N}.

There are different ways to control energy storage modules of each energy storage rack whose rack status value is to be modified. Some examples are presented below. The invention is not, however, limited to any of the below-presented examples.

### Example 3a of controlling energy storage modules within an energy storage rack:

In a control system according to an exemplifying and non-limiting embodiment, each of the rack controllers is configured to compute, for each of the energy storage modules of the respective energy storage rack, a balancing coefficient C_{bal} according to the following formula when the respective energy storage rack is to be controlled to modify its rack status value: ${C}_{bal_j} = \left({S}_{ce_j}+\left({S}_{cr_i}-{R}_{ref_i}\right)/M-{S}_{ce_min_i}\right) / \left({S}_{ce_max_i}-{S}_{ce_min_i}\right) ,$ (3) where C_{bal_j} is the balancing coefficient of the j^{th} one of the energy storage modules of i^{th} one of the energy storage racks, S_{ce_j} is the module status value, e.g. the voltage V_{ce_j} or SoC, of the j^{th} one of the energy storage modules of i^{th} one of the energy storage racks, R_{ref_i} is the rack reference value, e.g. a voltage reference V_{ref_cr_i} or SoC reference, of the i^{th} one of the energy storage racks, S_{cr_i} is the rack status value, e.g. the rack voltage V_{cr_i} or the SoC, of the i^{th} one of energy storage racks, M is the number of the series connected energy storage modules of the i^{th} one of the energy storage racks, S_{ce_min_i} is the smallest one of the module status values in the i^{th} one of the energy storage racks, and S_{ce_max_i} is the greatest one of the module status values in the i^{th} one of the energy storage racks. Each of the rack controllers is configured to determine that each of the energy storage modules of the respective energy storage rack, whose balancing coefficient is greater than a predetermined limit e.g. 0.95, is to be controlled with the respective one or more controllable discharge circuits.

### Example 3b of controlling energy storage modules within an energy storage rack:

**In** a control system according to an exemplifying and non-limiting embodiment, each of the rack controllers is configured to compute, for each of the energy storage modules of the respective energy storage rack, an updated module status value according to the following formula when the respective energy storage rack is to be controlled to modify its rack status value: ${S}_{new_ce_j} = {S}_{ce_j} + \left({R}_{ref_i}-{S}_{cr_i}\right) / M ,$ (4) where S_{new_ce_j} is the updated module status value, e.g. an updated voltage or SoC value, of j^{th} one of the energy storage modules of i^{th} one of the energy storage racks, S_{ce_j} is the module status value, e.g. the voltage V_{ce_j} or SoC, of the j^{th} one of the energy storage modules, R_{ref_i} is the rack reference value, e.g. a voltage reference V_{ref_cr_i} or SoC reference, of the i^{th} one of the energy storage racks, S_{cr_i} is the rack status value, e.g. the rack voltage V_{cr_i} or the SoC, of the i^{th} one of energy storage racks, and M is the number of the series connected energy storage modules of the i^{th} one of the energy storage racks. In this exemplifying case, the difference R_{ref_i} - S_{cr_i} between the reference and actual rack status values of the energy storage rack is equally distributed between all the energy storage modules, e.g. cells or modules including many cells, within the energy storage rack. Each of the rack controllers is configured to determine that each of the energy storage modules of the respective energy storage rack, whose updated module status value exceeds an arithmetic average (S_{new_ce_1} + ... S_{new_ce_M})/M of the updated module status values related to the energy storage rack with a predetermined margin, is to be controlled with the respective one or more controllable discharge circuits. Therefore, those of the energy storage modules whose updated module status values, e.g. voltages, are most above the above-mentioned arithmetic average and thus having biggest contributions on the voltage imbalance are determined to be controlled with the respective one or more controllable discharge circuits.

### Example 3c of controlling energy storage modules within an energy storage rack:

In a control system according to an exemplifying and non-limiting embodiment, each of the rack controllers is configured to compute, for each of the energy storage modules of the respective energy storage rack, a difference value according to the following formula when the respective energy storage rack is to be controlled to modify its rack status value: ${D}_{ce_j} = {S}_{ce_j} - {R}_{ref_i} / M ,$ (5) where D_{ce_j} is the difference value of j^{th} one of the energy storage modules of i^{th} one of the energy storage racks to be controlled, S_{ce_j} is the module status value, e.g. the voltage V_{ce_j} or SoC, of the j^{th} one of the energy storage modules of the i^{th} one of the energy storage racks, R_{ref_i} is the rack reference value, e.g. a voltage reference V_{ref_cr_i} or SoC reference, of the i^{th} one of the energy storage racks, and M is the number of the series connected energy storage modules of the i^{th} one of the energy storage racks. Each of the rack controllers is configured to determine that each of the capacitor entities of the respective energy storage rack, whose difference value exceeds a predetermined limit i.e. D_{ce_j} > limit, is to be controlled with the respective one or more controllable discharge circuits. In this exemplifying case, the rack reference R_{ref_i}, e.g. the voltage reference V_{ref_cr_i} or SoC reference, is equally distributed between all the energy storage modules i.e. the reference of each entity is R_{ref_i}/M, and then, for each energy storage module, the difference value D_{ce_j} being the difference between the actual module status value of the energy storage module and the reference value R_{ref_i}/M is computed. Then, those of the energy storage modules whose module status values, e.g. V_{ce_j}, are most above the reference value R_{ref_i}/M are determined to be controlled with the respective one or more controllable discharge circuits.

There are different ways to control energy storage modules of each energy storage rack the rack status value of which does not need to be modified but which may have imbalance internal to the energy storage rack. Some examples are presented below. The invention is not, however, limited to any of the below-presented examples.

### Example 4a of controlling energy storage modules within an energy storage rack:

In a control system according to an exemplifying and non-limiting embodiment, each of the rack controllers is configured to compute, for each of the energy storage modules of the respective energy storage rack, a balancing coefficient C_{bal} according to the following formula when the respective energy storage rack does not need to be controlled to modify its rack status value: ${C}_{bal_j} = \left({S}_{ce_j}-{S}_{ce_min_i}\right) / \left({S}_{ce_max_i}-{S}_{ce_min_i}\right) ,$ (6) where C_{bal_j} is the balancing coefficient of the j^{th} one of the energy storage modules of i^{th} one of the energy storage racks, S_{ce_j} is the module status value, e.g. the voltage V_{ce_j} or SoC, of the j^{th} one of the energy storage modules of the i^{th} one of the energy storage racks, S_{ce_min_i} is the smallest one of the module status values in the i^{th} one of the energy storage racks, and S_{ce_max_i} is the greatest one of the module status values in the i^{th} one of the energy storage racks. Each of the rack controllers is configured to determine that each of the energy storage modules of the respective energy storage rack, whose balancing coefficient is greater than a predetermined limit e.g. 0.95, is to be controlled with the respective one or more controllable discharge circuits.

### Example 4b of controlling energy storage modules within an energy storage rack:

**In** a control system according to an exemplifying and non-limiting embodiment, each of the rack controllers is configured to determine, in response to a situation in which the respective energy storage rack does not need to be controlled to modify its rack status value, that each of the energy storage modules of the respective energy storage rack, whose module status value exceeds an arithmetic average (S_{ce_1} + ... S_{ce_M})/M of the module status values related to the energy storage rack with a predetermined margin, is to be controlled with the respective one or more controllable discharge circuits. Therefore, those of the energy storage modules whose module status values, e.g. voltages, are most above the above-mentioned arithmetic average and thus having biggest contributions on the voltage imbalance are determined to be controlled with the respective one or more controllable discharge circuits.

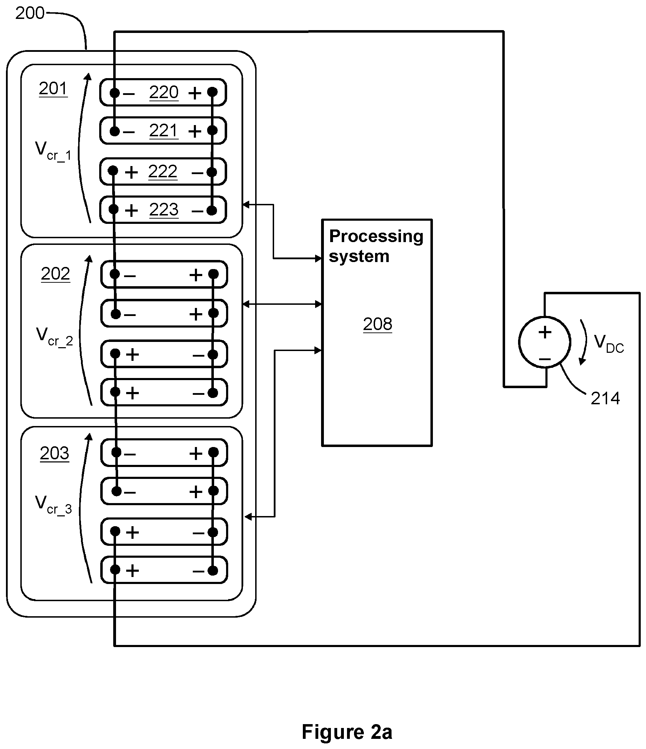

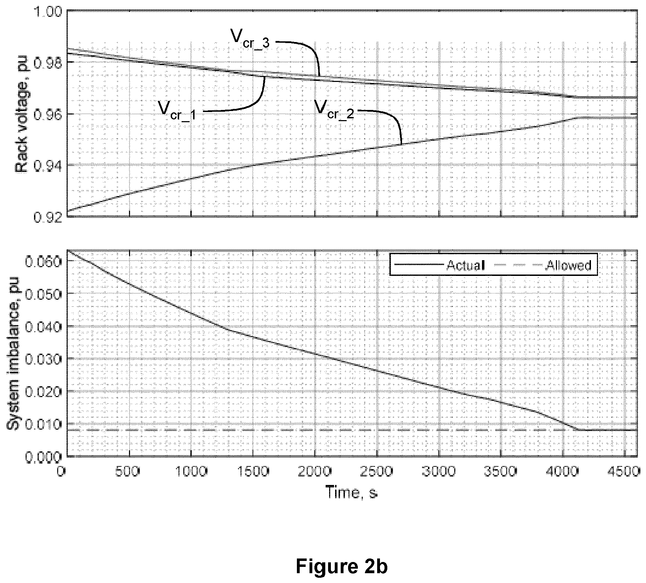

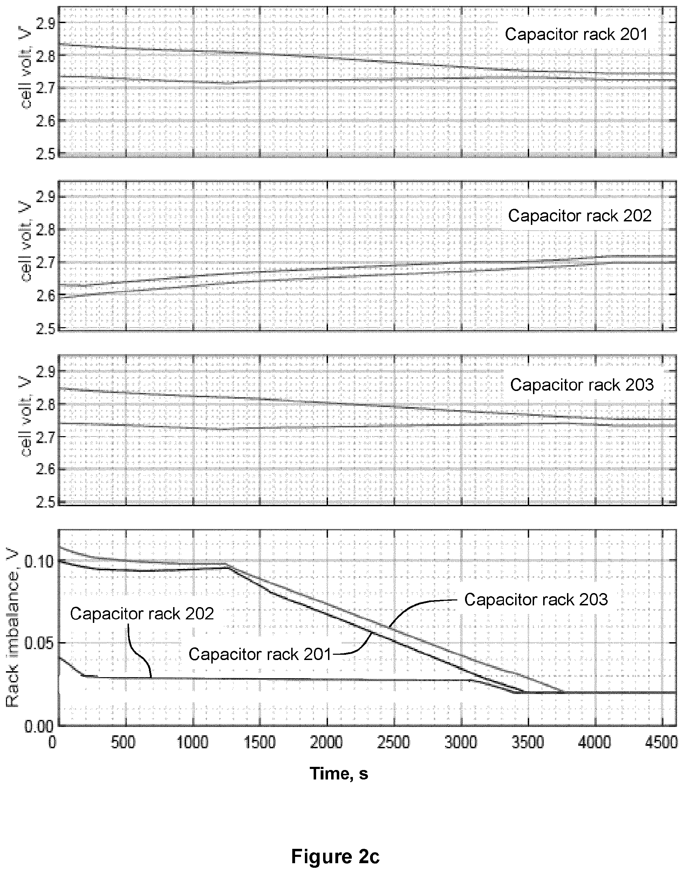

**Figure 2a** illustrates a control system according to an exemplifying and non-limiting embodiment for voltage balancing of an energy storage system 200. An electric circuitry for charging and discharging the energy storage system 200 is depicted as a direct voltage source 214. The energy storage system 200 comprises a string of series connected energy storage racks 201, 202, and 203. Each of the energy storage racks comprises four strings of capacitor cells so that each string has 36 series connected capacitor cells. In figure 2a, the strings of capacitor cells of the energy storage rack 201 are denoted with references 220, 221, 222, and 223. As shown in figure 2, each energy storage rack comprises 72 capacitor cells in series because the strings are pairwise connected in parallel and these parallel connections are, in turn, connected in series. Each of the capacitor cells is connected to a controllable discharge circuit that comprises a series connection of a dissipation resistor and a switch so that this series connection is in parallel with the capacitor cell. The switch can be e.g. a MOSFET. The controllable discharge circuits are not shown in figure 2a.

The control system comprises a data processing system 208 configured to determine, based on rack status values of the energy storage racks 201-203, which one or ones of the energy storage racks is/are to be controlled to modify respective one or ones of the rack status values to reduce voltage imbalance between the energy storage racks. In the exemplifying case shown in figure 2a, the rack status values of the energy storage racks 201-203 are voltages V_{cr_1}, V_{cr_2}, and V_{cr_3} of the energy storage racks. It is however also possible that the rack status values are state of charge "SoC" values of the energy storage racks 201-203. The data processing system 208 is configured to form a rack reference value, e.g. a voltage reference or a SoC reference, for at least each of the energy storage racks which have been determined to be controlled to modify its rack status value.

The data processing system 208 is configured to carry out the following actions for each of the energy storage racks:
- in response to a situation in which the energy storage rack is to be controlled to modify its rack status value, determining, based on at least i) module status values of the energy storage modules of the energy storage rack and ii) the rack reference value of the energy storage rack, which one or ones of these energy storage modules is/are to be controlled to reduce voltage imbalance between these energy storage modules and to drive the rack status value of the energy storage rack towards the rack reference value of the energy storage rack, and otherwise determining, based on at least the above-mentioned module status values, which one or ones of the energy storage modules belonging to the energy storage rack is/are to be controlled to reduce voltage imbalance between these energy storage modules, and
- controlling the controllable discharge circuits to discharge the one or more capacitor cells belonging to the one or ones of the energy storage modules determined to be controlled.

In this exemplifying case, the above-mentioned energy storage modules are the capacitor cells, and the module status values are correspondingly the cell voltages, wherein each energy storage rack comprises 72 capacitor cells in series so that the voltage of the energy storage rack is the sum of cell voltages of these 72 capacitor cells. As mentioned above, strings of 36 capacitor cells are in parallel, and the parallel connections are in series in each energy storage rack. The parallel connected strings can be balance-controlled individually so that voltages of the parallel connected strings are the same - as being parallel connected.

The functionalities related to the above-mentioned actions can be, for example, such as described above with reference to figure 1.

Figures 2b and 2c demonstrate a functionality of the control system illustrated in figure 2a in an exemplifying case where:
- the energy storage racks to be controlled to modify the rack status value are determined with the method according to example 1a presented above in this document,
- the rack reference values are formed with the method according to example 2a presented above in this document,
- **the balancing** within each energy storage rack, whose rack status value is to be modified, is carried out with the method according to example 3a presented above in this document, and
- the balancing within each energy storage rack, whose rack status value does not need to be modified, is carried out with the method according to example 4a presented above in this document.

In figures 2b and 2c, the functionality of the control system illustrated in figure 2a is demonstrated in an exemplifying situation in which the voltage of the energy storage system 200, i.e. voltage V_{DC} = V_{cr_1} + V_{cr_2} + V_{cr_3}, is hold at 590 volts and the energy storage system 200 has imbalance at the beginning of the operation of the control system so that V_{cr_1} ≈ 0.984 proportional unit "pu" at time = 0, V_{cr_2} ≈ 0.925 pu at time = 0, and V_{cr_3} ≈ 0.987 pu at time = 0, and thus the system imbalance as a difference between the maximum and minimum voltages, i.e. V_{cr_3} - V_{cr_2} at time = 0, is about 0.062 pu at time = 0 as shown in figure 2b. Figure 2b shows how the rack voltages V_{cr_1}, V_{cr_2}, and V_{cr_3} change towards each other so that the system imbalance decreases when the control system is operating. Figure 2c shows the maximum and minimum cell voltages within each of the energy storage racks 201-203 as functions of time when the control system is operating. Furthermore, figure 2c shows time trends of voltage imbalances, i.e. the maximum cell voltage - the minimum cell voltage, within each of the energy storage racks 201-203. It is to be noted that a cell having the maximum voltage may change over time and, correspondingly, a cell having the minimum voltage may change over time. As shown in figure 2c, the imbalances in energy storage racks 201 and 203 decrease slowly when time < 1250 seconds, which means that all the capacitor cells in these energy storage racks 201 and 203 are participating in the balancing, i.e. their controllable discharge circuits are activated, due to respective rack reference values in order to reduce the voltages V_{cr_1} and V_{cr_3} with respect to the voltage V_{cr_2}.

Each of the processors 109-112 shown in figure 1 as well as the data processing system 208 shown in figure 2a may comprise one or more analogue circuits, one or more digital processing circuits, or a combination thereof. Each digital processing circuit can be a programmable processor circuit provided with appropriate software, a dedicated hardware processor such as for example an application specific integrated circuit "ASIC", or a configurable hardware processor circuit such as for example a field programmable gate array "FPGA". Furthermore, each of the processors 109-112 shown in figure 1 as well as the data processing system 208 shown in figure 2a may comprise one or more memory circuits each of which can be for example a Random-Access Memory "RAM" circuit and/or a nonvolatile memory circuit such as e.g. an electrically erasable programmable read-only memory "EEPROM" circuit.

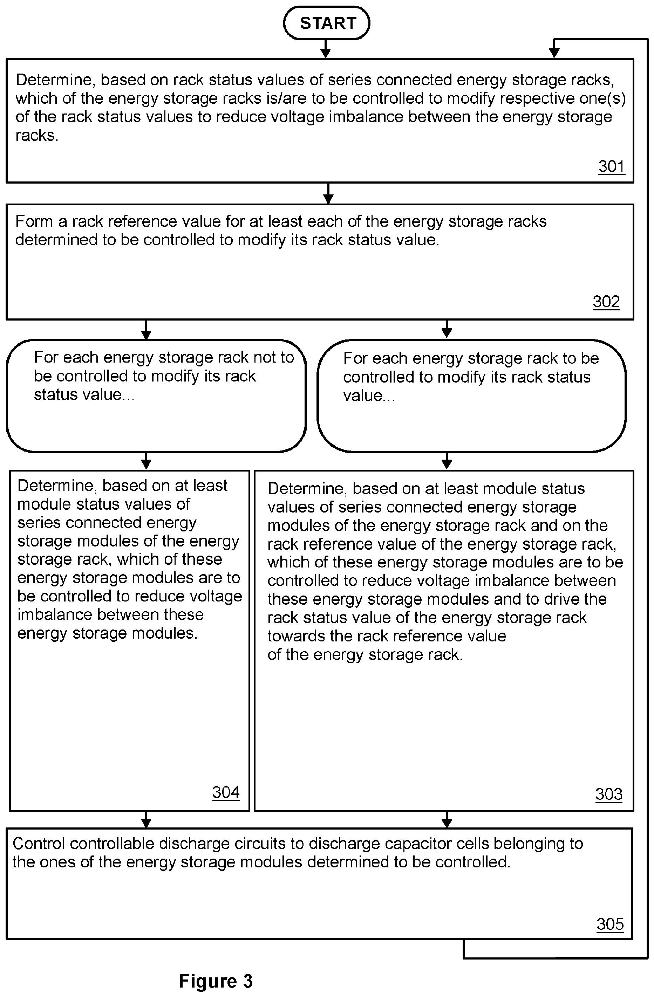

Figure 3 shows a flowchart of a method according to an exemplifying and non-limiting embodiment for voltage balancing of an energy storage system that comprises a string of series connected energy storage racks each comprising series connected energy storage modules each of which comprises one or more energy storage cells each being connected to a controllable discharge circuit for discharging the energy storage cell. The method comprises the following actions:
- action 301: determining, based on rack status values, e.g. voltages or states of charge "SoC", of the energy storage racks, which one or ones of the energy storage racks is/are to be controlled to modify respective one or ones of the rack status values to reduce voltage imbalance between the energy storage racks, the rack status values being directly proportional to the voltages of the energy storage racks, and
- action 302: forming a rack reference value for at least each of the energy storage racks determined to be controlled to modify its rack status value.

Furthermore, the method comprises the following actions for each of the energy storage racks:
- in response to a situation in which the energy storage rack is to be controlled to modify its rack status value: action 303 - determining, based on at least i) module status values, e.g. voltages or states of charge "SoC", of the energy storage modules of the energy storage rack and ii) the rack reference value of the energy storage rack, which one or ones of these energy storage modules is/are to be controlled to reduce voltage imbalance between these energy storage modules and to drive the rack status value of the energy storage rack towards the rack reference value of the energy storage rack, or
- in response to a situation in which the energy storage rack is to not be controlled to modify its rack status value: action 304 - determining, based on at least the module status values of the energy storage modules of the energy storage rack, which one or ones of the energy storage modules belonging to the energy storage rack is/are to be controlled to reduce voltage imbalance between these energy storage modules, and
- action 305: controlling the controllable discharge circuits to discharge the one or more energy storage cells belonging to the one or ones of the energy storage modules determined to be controlled.

A method according to an exemplifying and non-limiting embodiment comprises computing, for each of the energy storage racks, a string balancing coefficient according to the following formula: ${C}_{bs_i} = \left({S}_{cr_i}-{minS}_{cr}\right) / \left({maxS}_{cr}-{minS}_{cr}\right) ,$ where C_{bs_i} is the string balancing coefficient of i^{th} one of the energy storage racks, S_{cr_i} is the rack status value of the i^{th} one of the energy storage racks, minS_{cr} is the smallest one of the rack status values of the energy storage racks, and maxS_{cr} is the greatest one of the rack status values of the energy storage racks, and each of the energy storage racks, whose string balancing coefficient exceeds a predetermined limit e.g. 0.95, is determined to be controlled to modify its rack status value.

A method according to an exemplifying and non-limiting embodiment comprises forming, for each of the energy storage racks to be controlled to modify its rack status value, an offset as a decreasing function of the rack status value of the energy storage rack and forming, for each of the energy storage racks to be controlled to modify its rack status value, the rack reference value as a sum of the offset and the smallest one of the rack status values of the energy storage racks. This embodiment can be completed with a condition that the energy storage rack under consideration is controlled only if the offset formed for the energy storage rack under consideration is less than a difference between the greatest one of the rack status values of the energy storage racks and the smallest one of the rack status values.

**In** a method according to an exemplifying and non-limiting embodiment, each of the energy storage racks, whose rack status value exceeds a predetermined minimum balancing value, is determined to be controlled to modify its rack status value.

A method according to an exemplifying and non-limiting embodiment comprises computing, for at least each of the energy storage racks whose status value exceeds the predetermined minimum balancing value, the rack reference value according to the following formula: ${R}_{ref_i} = {S}_{set} - \left({C}_{min}/{C}_{i}\right) \left({S}_{set}-{S}_{min_C}\right) ,$ where R_{ref_i} is the rack reference value for i^{th} one of the energy storage racks, Cᵢ is an estimate of capacitance of the i^{th} one of the energy storage racks, Cₘᵢₙ is the smallest one of the estimates of the capacitances of the energy storage racks, is S_{min_C} is the rack status value of the energy storage rack having the smallest capacitance Cₘᵢₙ, and Sₛₑₜ is a set point value such that the imbalance between the energy storage racks is minimized when the rack status values of the energy storage racks have the set point value.

**In** a method according to an exemplifying and non-limiting embodiment, the rack status values of the energy storage racks are the voltages of the energy storage racks, and the rack reference values of the energy storage racks are reference values of the voltages of the energy storage racks. **In** a method according to another exemplifying and non-limiting embodiment, the rack status values of the energy storage racks are the state of charge "SoC" values of the energy storage racks, and the rack reference values of the energy storage racks are reference values of the states of charge of the energy storage racks.

A method according to an exemplifying and non-limiting embodiment comprises forming the rack reference values for all the energy storage racks so that the rack reference value has a predetermined flag value, e.g. zero, in response to a situation in which the respective one of the energy storage racks is not to be controlled to modify its rack status value. **In** this exemplifying embodiment, each rack reference value also acts as an indicator expressing whether, or not, the respective energy storage rack is to be controlled to modify its rack status value.

A method according to an exemplifying and non-limiting embodiment comprises computing, for each of the energy storage modules of each energy storage rack, a balancing coefficient C_{bal} according to the following formula when the energy storage rack is to be controlled to modify its rack status value: ${C}_{bal_j} = \left({S}_{ce_j}+\left({S}_{cr_i}-{R}_{ref_i}\right)/M-{S}_{ce_min_i}\right) / \left({S}_{ce_max_i}-{S}_{ce_min_i}\right) ,$ where C_{bal_j} is the balancing coefficient of the j^{th} one of the energy storage modules of i^{th} one of the energy storage racks, S_{ce_j} is the module status value, e.g. the voltage V_{ce_j} or SoC, of the j^{th} one of the energy storage modules of i^{th} one of the energy storage racks, R_{ref_i} is the rack reference value, e.g. a voltage reference V_{ref_cr_i} or SoC reference, of the i^{th} one of the energy storage racks, S_{cr_i} is the rack status value, e.g. the rack voltage V_{cr_i} or the SoC, of the i^{th} one of energy storage racks, M is the number of the series connected energy storage modules of the i^{th} one of the energy storage racks, S_{ce_min_i} is the smallest one of the module status values in the i^{th} one of the energy storage racks, and S_{ce_max_i} is the greatest one of the module status values in the i^{th} one of the energy storage racks. Each of the rack controllers is configured to determine that each of the energy storage modules of the respective energy storage rack, whose balancing coefficient is greater than a predetermined limit e.g. 0.95, is to be controlled with the respective one or more controllable discharge circuits.

A method according to an exemplifying and non-limiting embodiment comprises computing, for each of the energy storage modules of each of the energy storage racks to be controlled to modify its rack status value, a difference value according to the following formula: ${D}_{ce_j} = {S}_{ce_j} - {R}_{ref_i} / M ,$ where D_{ce_j} is the difference value of j^{th} one of the energy storage modules of i^{th} one of the energy storage racks to be controlled, S_{ce_j} is the module status value of the j^{th} one of the energy storage modules, R_{ref_i} is the rack reference value of the i^{th} one of the energy storage racks, and M is the number of the series connected energy storage modules of the i^{th} one of the energy storage racks, and each of the capacitor entities, whose difference value exceeds a predetermined imbalance limit, is determined to be controlled with the respective one or more controllable discharge circuits.

A method according to an exemplifying and non-limiting embodiment comprises computing, for each of the energy storage modules of each of the energy storage racks to be controlled to modify its rack status value, an updated module status value according to the following formula: ${S}_{new_ce_j} = {S}_{ce_j} + \left({R}_{ref_i}-{S}_{cr_i}\right) / M ,$ where S_{new_ce_j} is the updated module status value of j^{th} one of the energy storage modules of i^{th} one of the energy storage racks, S_{ce_j} is the module status value of the j^{th} one of the energy storage modules, R_{ref_i} is the rack reference value of the i^{th} one of the energy storage racks, S_{cr_i} is the rack status value of the i^{th} one of energy storage racks, and M is the number of the series connected energy storage modules of the i^{th} one of the energy storage racks, and each of the capacitor entities, whose updated module status value exceeds an arithmetic average of the updated module status values with a predetermined margin, is determined to be controlled with the respective one or more controllable discharge circuits.

A method according to an exemplifying and non-limiting embodiment comprises computing, for each of the energy storage modules of each energy storage rack, a balancing coefficient C_{bal} according to the following formula when the energy storage rack does not need to be controlled to modify its rack status value: ${C}_{bal_j} = \left({S}_{ce_j}-{S}_{ce_min_i}\right) / \left({S}_{ce_max_i}-{S}_{ce_min_i}\right) ,$ where C_{bal_j} is the balancing coefficient of the j^{th} one of the energy storage modules of i^{th} one of the energy storage racks, S_{ce_j} is the module status value, e.g. the voltage V_{ce_j} or SoC, of the j^{th} one of the energy storage modules of the i^{th} one of the energy storage racks, S_{ce_min_i} is the smallest one of the module status values in the i^{th} one of the energy storage racks, and S_{ce_max_i} is the greatest one of the module status values in the i^{th} one of the energy storage racks. Each of the rack controllers is configured to determine that each of the energy storage modules of the respective energy storage rack, whose balancing coefficient is greater than a predetermined limit e.g. 0.95, is to be controlled with the respective one or more controllable discharge circuits.

A method according to an exemplifying and non-limiting embodiment comprises determining, in response to a situation in which an energy storage rack does not need to be controlled to modify its rack status value, that each of the energy storage modules of the energy storage rack, whose module status value exceeds an arithmetic average (S_{ce_1} + ... S_{ce_M})/M of the module status values related to the energy storage rack with a predetermined margin, is to be controlled with the respective one or more controllable discharge circuits. Therefore, those of the energy storage modules whose module status values, e.g. voltages, are most above the above-mentioned arithmetic average and thus having biggest contributions on the voltage imbalance are determined to be controlled with the respective one or more controllable discharge circuits.

In a method according to an exemplifying and non-limiting embodiment, the module status values of the energy storage modules are the voltages of the energy storage modules, and the rack reference values of the energy storage racks are reference values of the voltages of the energy storage racks. In a method according to another exemplifying and non-limiting embodiment, the module status values of the energy storage modules are state of charge "SoC" values of the energy storage modules, and the rack reference values of the energy storage racks are reference values of the states of charge of the energy storage racks.

In a method according to an exemplifying and non-limiting embodiment, each of the energy storage cells is a capacitor cell or a hybrid energy storage cell. A capacitor cell can be for example a foil capacitor cell, an electrolytic capacitor cell, or a super-capacitor cell such as a carbon capacitor cell or an electric double layer capacitor "EDLC" cell. The hybrid energy storage cell can be considered an energy storage device that comprises active materials with a predominately faradaic charge storage mechanism, i.e. metal oxides, phosphates or graphite, so classical battery active materials, but which also comprises predominately capacitive charge storage mechanisms.

A computer program according to an exemplifying and non-limiting embodiment for voltage balancing of an energy storage system comprises computer executable instructions for controlling a programmable data processing system to carry out actions related to a method according to any of the above-described exemplifying and non-limiting embodiments.

A computer program according to an exemplifying and non-limiting embodiment comprises software modules for voltage balancing of an energy storage system that comprises a string of series connected energy storage racks each comprising series connected energy storage modules each of which comprises one or more energy storage cells each being connected to a controllable discharge circuit for discharging the energy storage cell. The software modules comprise computer executable instructions for controlling a programmable data processing system to:
- determine, based on rack status values, e.g. voltages or states of charge "SoC", of the energy storage racks, which one or ones of the energy storage racks is/are to be controlled to modify respective one or ones of the rack status values to reduce voltage imbalance between the energy storage racks, the rack status values being directly proportional to voltages of the energy storage racks, and
- form a rack reference value for at least each of the energy storage racks determined to be controlled to modify its rack status value,

Furthermore, the software modules comprise computer executable instructions for controlling the programmable data processing system to carry out the following actions for each of the energy storage racks:
- in response to a situation in which the energy storage rack is to be controlled to modify its rack status value, determining, based on at least i) module status values of the energy storage modules of the energy storage rack and ii) the rack reference value of the energy storage rack, which one or ones of these energy storage modules is/are to be controlled to reduce voltage imbalance between these energy storage modules and to drive the rack status value of the energy storage rack towards the rack reference value of the energy storage rack, and otherwise determining, based on at least the above-mentioned module status values, which one or ones of the energy storage modules belonging to the energy storage rack is/are to be controlled to reduce voltage imbalance between these energy storage modules, and
- controlling the controllable discharge circuits to discharge the one or more energy storage cells belonging to the one or ones of the energy storage modules determined to be controlled.

The software modules can be, for example, subroutines or functions implemented with programming tools suitable for the programmable data processing system.

A computer program product according to an exemplifying and non-limiting embodiment comprises a computer readable medium, e.g. an EEPROM, a USB memory, or a compact disc "CD", encoded with a computer program according to an exemplifying embodiment of the invention.

A signal according to an exemplifying and non-limiting embodiment is encoded to carry information defining a computer program according to an exemplifying embodiment of the invention.

A non-volatile computer readable medium, e.g. an EEPROM, a USB memory, or a CD ROM, according to an exemplifying and non-limiting embodiment is encoded with a computer program according to an exemplifying embodiment of the invention.

The specific examples provided in the description given above should not be construed as limiting the applicability and/or the interpretation of the invention. Lists and groups of examples provided in the description given above are not exhaustive unless otherwise explicitly stated.

## Claims

1. A control system for voltage balancing of an energy storage system that comprises a string of series connected energy storage racks (101-103, 201-203) each comprising series connected energy storage modules (104-106, 204, 205) each comprising one or more energy storage cells each being connected to a controllable discharge circuit (107) for discharging the energy storage cell, the system comprising a data processing system (108, 208) configured to:
- determine, based on rack status values (V_{cr_1}, ..., V_{cr_N}) of the energy storage racks, which one or ones of the energy storage racks is/are to be controlled to modify respective one or ones of the rack status values to reduce voltage imbalance between the energy storage racks, the rack status values being directly proportional to voltages of the energy storage racks, and
- form a rack reference value (V_{ref_cr_1}, ..., V_{ref_cr_N}) for at least each of the energy storage racks determined to be controlled to modify its rack status value,
wherein the data processing system is configured to carry out the following actions for each of the energy storage racks:
- in response to a situation in which the energy storage rack is to be controlled to modify its rack status value, determining, based on at least i) module status values (V_{ce_1}, ..., V_{ce_M}) of the energy storage modules of the energy storage rack and ii) the rack reference value (V_{ref_cr_i}) of the energy storage rack, which one or ones of these energy storage modules is/are to be controlled to reduce voltage imbalance between these energy storage modules and to drive the rack status value (V_{ce_i}) of the energy storage rack towards the rack reference value (V_{ref_cr_i}) of the energy storage rack, and otherwise determining, based on at least these module status values (V_{ce_1}, ..., V_{ce_M}), which one or ones of the energy storage modules belonging to the energy storage rack is/are to be controlled to reduce voltage imbalance between these energy storage modules, and
- controlling the controllable discharge circuits to discharge the one or more energy storage cells belonging to the one or ones of the energy storage modules determined to be controlled,
**characterized in that** the data processing system is configured to form, for each of the energy storage racks to be controlled to modify its rack status value, an offset (V_{cr_off_i}) as a decreasing function of the rack status value (V_{cr_i}) of the energy storage rack and to form, for each of the energy storage racks to be controlled to modify its rack status value, the rack reference value (V_{ref_cr_i}) as a sum (V_{cr_off_i} + minV_{cr}) of the offset and a smallest one of the rack status values of the energy storage racks.

2. A control system according to claim 1, wherein the data processing system is configured to compute, for each of the energy storage racks, a string balancing coefficient according to a following formula: ${C}_{bs_i } = \left({S}_{cr_i} - {minS}_{cr}\right) / \left({maxS}_{cr} - {minS}_{cr}\right) ,$ where C_{bs_i} is the string balancing coefficient of i^{th} one of the energy storage racks, S_{cr_i} is the rack status value of the i^{th} one of the energy storage racks, minS_{cr} is a smallest one of the rack status values of the energy storage racks, and maxS_{cr} is a greatest one of the rack status values of the energy storage racks, and the data processing system is configured to determine each of the energy storage racks, whose string balancing coefficient exceeds a first predetermined limit, to be controlled to modify its rack status value.

3. A control system according to claim 1 or 2, wherein the data processing system is configured to determine each of the energy storage racks, whose rack status value exceeds a predetermined minimum balancing value, to be controlled to modify its rack status value.

4. A control system according to any one of claims 1-3, wherein the rack status values of the energy storage racks are voltages (V_{cr_1}, ..., V_{cr_N}) of the energy storage racks, and the rack reference values of the energy storage racks are reference values (V_{ref_Cr_1}, ..., V_{ref_cr_N}) of the voltages (V_{cr_1}, ..., V_{cr_N}) of the energy storage racks.

5. A control system according to any one of claims 1-3, wherein the rack status values of the energy storage racks are state of charge values of the energy storage racks, and the rack reference values of the energy storage racks are reference values of the states of charge of the energy storage racks.

6. A control system according to any one of claims 1-5, wherein the data processing system is configured to form the rack reference values for all the energy storage racks so that the rack reference value has a predetermined flag value in response to a situation in which the respective one of the energy storage racks is not to be controlled to modify its rack status value.

7. A control system according to any one of claims 1-6, wherein the data processing system is configured to compute, for each of the energy storage modules of each of the energy storage racks to be controlled to modify its rack status value, a balancing coefficient according to a following formula: ${C}_{bal_j} = \left({S}_{ce_j}+\left({S}_{cr_i}-{R}_{ref_i}\right)/M-{S}_{ce_min_i}\right) / \left({S}_{ce_max_i}-{S}_{ce_min_i}\right) ,$ where C_{bal_j} is the balancing coefficient of the j^{th} one of the energy storage modules of i^{th} one of the energy storage racks, S_{ce_j} is the module status value of the j^{th} one of the energy storage modules of i^{th} one of the energy storage racks, R_{ref_i} is the rack reference value of the i^{th} one of the energy storage racks, S_{cr_i} is the rack status value of the i^{th} one of energy storage racks, M is the number of the series connected energy storage modules of the i^{th} one of the energy storage racks, S_{ce_min_i} is the smallest one of the module status values in the i^{th} one of the energy storage racks, and S_{ce_max_i} is the greatest one of the module status values in the i^{th} one of the energy storage racks, and the data processing system is configured to determine that each of the energy storage modules, whose balancing coefficient is greater than a predetermined limit, is to be controlled with the respective one or more controllable discharge circuits.

8. A control system according to any one of claims 1-6, wherein the data processing system is configured to compute, for each of the energy storage modules of each of the energy storage racks to be controlled to modify its rack status value, an updated module status value according to a following formula: ${S}_{new_ce_j} = {S}_{ce_j} + \left({R}_{ref_i}-{S}_{cr_i}\right) / M ,$ where S_{new_ce_j} is the updated module status value of j^{th} one of the energy storage modules of i^{th} one of the energy storage racks, S_{ce_j} is the module status value of the j^{th} one of the energy storage modules, R_{ref_i} is the rack reference value of the i^{th} one of the energy storage racks, S_{cr_i} is the rack status value of the i^{th} one of energy storage racks, and M is number of the series connected energy storage modules of the i^{th} one of the energy storage racks, and the data processing system is configured to determine that each of the energy storage modules, whose updated module status value exceeds an arithmetic average of the updated module status values with a predetermined margin, is to be controlled with the respective one or more controllable discharge circuits.

9. A control system according to any one of claims 1-8, wherein the module status values of the energy storage modules are voltages (V_{ce_1}, ..., V_{ce_M}) of the energy storage modules, and the rack reference values of the energy storage racks are reference values (V_{ref_Cr_1}, ..., V_{ref_cr_N}) of the voltages (V_{cr_1}, ..., V_{cr_N}) of the energy storage racks.

10. A control system according to any one of claims 1-9, wherein the module status values of the energy storage modules comprise state of charge values of the energy storage modules, and the rack reference values of the energy storage racks are reference values of the states of charge of the energy storage racks.

11. A method for voltage balancing of an energy storage system that comprises a string of series connected energy storage racks (101-103, 201-203) each comprising series connected energy storage modules (104-106, 204, 205) each comprising one or more energy storage cells each being connected to a controllable discharge circuit (107) for discharging the energy storage cell, the method comprising:
- determining (301), based on rack status values (V_{cr_1}, ..., V_{cr_N}) of the energy storage racks, which one or ones of the energy storage racks is/are to be controlled to modify respective one or ones of the rack status values to reduce voltage imbalance between the energy storage racks, the rack status values being directly proportional to voltages of the energy storage racks, and
- forming (302) a rack reference value (V_{ref_cr_1}, ..., V_{ref_cr_N}) for at least each of the energy storage racks determined to be controlled to modify its rack status value,
wherein the method comprises for each of the energy storage racks:
- in response to a situation in which the energy storage rack is to be controlled to modify its rack status value, determining (303), based on at least i) module status values (V_{ce_1}, ..., V_{ce_M}) of the energy storage modules of the energy storage rack and ii) the rack reference value (V_{ref_Cr_i}) of the energy storage rack, which one or ones of these energy storage modules is/are to be controlled to reduce voltage imbalance between these energy storage modules and to drive the rack status value (V_{cr_i}) of the energy storage rack towards the rack reference value (V_{ref_cr_i}) of the energy storage rack, and otherwise determining (304), based on at least these module status values (V_{ce_1}, ..., V_{ce_M}), which one or ones of the energy storage modules belonging to the energy storage rack is/are to be controlled to reduce voltage imbalance between these energy storage modules, and
- controlling (305) the controllable discharge circuits to discharge the one or more energy storage cells belonging to the one or ones of the energy storage modules determined to be controlled,
**characterized in that** the method comprises forming, for each of the energy storage racks to be controlled to modify its rack status value, an offset (V_{cr_off_i}) as a decreasing function of the rack status value (V_{cr_i}) of the energy storage rack and forming, for each of the energy storage racks to be controlled to modify its rack status value, the rack reference value (V_{ref_cr_i}) as a sum (V_{cr_off_i} + minV_{cr}) of the offset and a smallest one of the rack status values of the energy storage racks.

12. A method according to claim 11, wherein each of the energy storage cells is a capacitor cell or a hybrid energy storage cell.

13. A computer program for voltage balancing of an energy storage system that comprises a string of series connected energy storage racks (101-103, 201-203) each comprising series connected energy storage modules (104-106, 204, 205) each comprising one or more energy storage cells each being connected to a controllable discharge circuit (107) for discharging the energy storage cell, the computer program comprising computer executable instructions for controlling a programmable data processing system to:
- determine, based on rack status values (V_{cr_1}, ..., V_{cr_N}) of the energy storage racks, which one or ones of the energy storage racks is/are to be controlled to modify respective one or ones of the rack status values to reduce voltage imbalance between the energy storage racks, the rack status values being directly proportional to voltages of the energy storage racks, and
- form a rack reference value (V_{ref_cr_1}, ..., V_{ref_cr_N}) for at least each of the energy storage racks determined to be controlled to modify its rack status value,
wherein the computer program further comprises computer executable instructions for controlling the programmable data processing system to carry out the following actions for each of the energy storage racks:
- in response to a situation in which the energy storage rack is to be controlled to modify its rack status value, determining, based on at least i) module status values (V_{ce_1}, ..., V_{ce_M}) of the energy storage modules of the energy storage rack and ii) the rack reference value (V_{ref_cr_i}) of the energy storage rack, which one or ones of these energy storage modules is/are to be controlled to reduce voltage imbalance between these energy storage modules and to drive the rack status value (V_{cr_i}) of the energy storage rack towards the rack reference value (V_{ref_cr_i}) of the energy storage rack, and otherwise determining, based on at least these module status values (V_{ce_1}, ..., V_{ce_M}), which one or ones of the energy storage modules belonging to the energy storage rack is/are to be controlled to reduce voltage imbalance between these energy storage modules, and
- controlling the controllable discharge circuits to discharge the one or more energy storage cells belonging to the one or ones of the energy storage modules determined to be controlled,
**characterized in that** the computer program comprises computer executable instructions for controlling the programmable data processing system to form, for each of the energy storage racks to be controlled to modify its rack status value, an offset (V_{cr_off_i}) as a decreasing function of the rack status value (V_{cr_i}) of the energy storage rack and to form for each of the energy storage racks to be controlled to modify its rack status value, the rack reference value (V_{ref_cr_i}) as a sum (V_{cr_off_i} + minV_{cr}) of the offset and a smallest one of the rack status values of the energy storage racks.

## Patentansprüche

1. Steuersystem zum Spannungsausgleich eines Energiespeichersystems, das einen Strang von in Reihe verbundenen Energiespeicherracks (101-103, 201-203) umfasst, die jeweils in Reihe verbundene Energiespeichermodule (104-106, 204, 205) umfassen, von denen jedes eine oder mehrere Energiespeicherzellen umfasst, die jeweils mit einer steuerbaren Entladeschaltung (107) zum Entladen der Energiespeicherzelle verbunden sind, wobei das System ein Datenverarbeitungssystem (108, 208) umfasst, das eingerichtet ist:
- basierend auf Rackzustandswerten (V_{cr}_₁, ..., V_{cr}__{N}) der Energiespeicherracks zu bestimmen, welches oder welche der Energiespeicherracks zu steuern sind, um den oder die entsprechenden der Rackzustandswerte zu ändern und ein Spannungsungleichgewicht zwischen den Energiespeicherracks zu reduzieren, wobei die Rackzustandswerte direkt proportional zu den Spannungen der Energiespeicherracks sind, und
- einen Rackreferenzwert (V_{ref}__{cr}_₁, ..., V_{ref}__{cr}__{N}) für mindestens jedes der Energiespeicherracks zu bilden, die dazu bestimmt sind, gesteuert zu werden, um ihren Rackzustandswert zu ändern,
wobei das Datenverarbeitungssystem eingerichtet ist, für jedes der Energiespeicherracks die folgenden Aktionen durchzuführen:
- als Reaktion auf eine Situation, in der das Energiespeicherrack zu steuern ist, um seinen Rackzustandswert zu ändern, Bestimmen, basierend auf mindestens i) Modulzustandswerten (V_{ce}_₁, ..., V_{ce}__{M}) der Energiespeichermodule des Energiespeicherracks und ii) dem Rackreferenzwert (V_{ref}__{cr}_ᵢ) des Energiespeicherracks, welches oder welche dieser Energiespeichermodule zu steuern sind, um ein Spannungsungleichgewicht zwischen diesen Energiespeichermodulen zu reduzieren und den Rackzustandswert (V_{ce}_ᵢ) des Energiespeicherracks in Richtung des Rackreferenzwerts (V_{ref}__{cr}_ᵢ) des Energiespeicherracks anzusteuern, und andernfalls Bestimmen, basierend auf mindestens diesen Modulzustandswerten (V_{ce}_₁, ..., V_{ce}__{M}), welches oder welche der zu dem Energiespeicherrack gehörenden Energiespeichermodule zu steuern sind, um ein Spannungsungleichgewicht zwischen diesen Energiespeichermodulen zu reduzieren, und
- Steuern der steuerbaren Entladeschaltungen, um die eine oder die mehreren Energiespeicherzellen zu entladen, die zu den ein oder mehreren der Energiespeichermodule gehören, die dazu bestimmt sind, gesteuert zu werden,
**dadurch gekennzeichnet, dass** das Datenverarbeitungssystem eingerichtet ist, für jedes der Energiespeicherracks, das zu steuern ist, um seinen Rackzustandswert zu ändern, einen Offset (V_{cr}__{off}_ᵢ) als fallende Funktion des Rackzustandswerts (V_{cr}_ᵢ) des Energiespeicherracks zu bilden, und für jedes der Energiespeicherracks, das zu steuern ist, um seinen Rackzustandswert zu ändern, den Rackreferenzwert (V_{ref}__{cr}_ᵢ) als Summe (V_{cr}__{off}_ᵢ + minV_{cr}) aus dem Offset und dem kleinsten der Rackzustandswerte der Energiespeicherracks zu bilden.

2. Steuersystem nach Anspruch 1, wobei das Datenverarbeitungssystem eingerichtet ist, für jedes der Energiespeicherracks einen Strangausgleichskoeffizienten gemäß der folgenden Formel zu berechnen: ${C}_{bs_i} = \left({S}_{cr_i}-{minS}_{cr}\right) / \left({maxS}_{cr}-{minS}_{cr}\right) ,$ wobei C_{bs}_ᵢ der Strangausgleichskoeffizient des i^{ten} der Energiespeicherracks ist, S_{cr}_ᵢ der Rackzustandswert des i^{ten} der Energiespeicherracks ist, minS_{cr} ein kleinster der Rackzustandswerte der Energiespeicherracks ist und maxS_{cr} ein größter der Rackzustandswerte der Energiespeicherracks ist, und wobei das Datenverarbeitungssystem eingerichtet ist, jedes der Energiespeicherracks zu bestimmen, dessen Strangausgleichskoeffizient einen ersten vorgegebenen Grenzwert überschreitet, sodass es zu steuern ist, um seinen Rackzustandswert zu ändern.

3. Steuersystem nach Anspruch 1 oder 2, wobei das Datenverarbeitungssystem eingerichtet ist, jedes der Energiespeicherracks zu bestimmen, dessen Rackzustandswert einen vorgegebenen Minimumausgleichswert überschreitet, sodass es zu steuern ist, um seinen Rackzustandswert zu ändern.

4. Steuersystem nach einem der Ansprüche 1 bis 3, wobei die Rackzustandswerte der Energiespeicherracks Spannungen (V_{cr}_₁, ..., V_{cr}__{N}) der Energiespeicherracks sind und die Rackreferenzwerte der Energiespeicherracks Referenzwerte (V_{ref}__{cr}_₁, ..., V_{ref}__{cr}__{N}) der Spannungen (V_{cr}_₁, ..., V_{cr}__{N}) der Energiespeicherracks sind.

5. Steuersystem nach einem der Ansprüche 1 bis 3, wobei die Rackzustandswerte der Energiespeicherracks Ladezustandswerte der Energiespeicherracks sind und die Rackreferenzwerte der Energiespeicherracks Referenzwerte der Ladezustände der Energiespeicherracks sind.

6. Steuersystem nach einem der Ansprüche 1 bis 5, wobei das Datenverarbeitungssystem eingerichtet ist, die Rackreferenzwerte für alle Energiespeicherracks zu bilden, sodass der Rackreferenzwert als Reaktion auf eine Situation, in der das entsprechende der Energiespeicherracks nicht zu steuern ist, um seinen Rackzustandswert zu ändern, einen vorgegebenen Flag-Wert aufweist.

7. Steuersystem nach einem der Ansprüche 1 bis 6, wobei das Datenverarbeitungssystem eingerichtet ist, für jedes der Energiespeichermodule von jedem der Energiespeicherracks, das zu steuern ist, um seinen Rackzustandswert zu ändern, einen Ausgleichskoeffizienten gemäß der folgenden Formel zu berechnen: ${C}_{bal_j} = \left({S}_{ce_j}+\left({S}_{cr_i}-{R}_{ref_i}\right)/M-{S}_{ce_min_i}\right) / \left({S}_{ce_max_i}-{S}_{ce_min_i}\right) ,$ wobei C_{bal}_ⱼ der Ausgleichskoeffizient des j^{ten} der Energiespeichermodule des i^{ten} der Energiespeicherracks ist, S_{ce}_ⱼ der Modulzustandswert des j^{ten} der Energiespeichermodule des i^{ten} der Energiespeicherracks ist, R_{ref}_ᵢ der Rackreferenzwert des i^{ten} der Energiespeicherracks ist, S_{cr}_ᵢ der Rackzustandswert des i^{ten} der Energiespeicherracks ist, M die Anzahl der in Reihe verbundenen Energiespeichermodule des i^{ten} der Energiespeicherracks ist, S_{ce}_ₘᵢₙ_ᵢ der kleinste der Modulzustandswerte im i^{ten} der Energiespeicherracks ist und S_{ce}_ₘₐₓ_ᵢ der größte der Modulzustandswerte im i^{ten} der Energiespeicherracks ist, und wobei das Datenverarbeitungssystem eingerichtet ist, zu bestimmen, dass jedes der Energiespeichermodule, dessen Ausgleichskoeffizient größer als ein vorbestimmter Grenzwert ist, mit den entsprechenden ein oder mehreren steuerbaren Entladeschaltungen zu steuern ist.

8. Steuersystem nach einem der Ansprüche 1 bis 6, wobei das Datenverarbeitungssystem eingerichtet ist, für jedes der Energiespeichermodule von jedem der Energiespeicherracks, die zu steuern sind, um ihren Rackzustandswert zu ändern, einen aktualisierten Modulzustandswert gemäß der folgenden Formel zu berechnen: ${S}_{new_ce_j} = {S}_{ce_j} + \left({R}_{ref_i}-{S}_{cr_i}\right) / M ,$ wobei S_{new}__{ce}_ⱼ der aktualisierte Modulzustandswert des j^{ten} der Energiespeichermodule des i^{ten} der Energiespeicherracks ist, S_{ce}_ⱼ der Modulzustandswert des j^{ten} der Energiespeichermodule ist, R_{ref}_ᵢ der Rackreferenzwert des i^{ten} der Energiespeicherracks ist, S_{cr}_ᵢ der Rackzustandswert des i^{ten} der Energiespeicherracks ist und M die Anzahl der in Reihe verbundenen Energiespeichermodule des i^{ten} der Energiespeicherracks ist, und wobei das Datenverarbeitungssystem eingerichtet, zu bestimmen, dass jedes der Energiespeichermodule, dessen aktualisierter Modulzustandswert einen arithmetischen Mittelwert der aktualisierten Modulzustandswerte um eine vorgegebene Marge überschreitet, mit den entsprechenden ein oder mehreren steuerbaren Entladeschaltungen zu steuern ist.

9. Steuersystem nach einem der Ansprüche 1 bis 8, wobei die Modulzustandswerte der Energiespeichermodule Spannungen (V_{ce}_₁, ..., V_{ce}__{M}) der Energiespeichermodule sind und die Rackreferenzwerte der Energiespeicherracks Referenzwerte (V_{ref}__{cr}_₁, ..., V_{ref}__{cr}__{N}) der Spannungen (V_{cr}_₁, ..., V_{cr}__{N}) der Energiespeicherracks sind.

10. Steuersystem nach einem der Ansprüche 1 bis 9, wobei die Modulzustandswerte der Energiespeichermodule Ladezustandswerte der Energiespeichermodule umfassen und die Rackreferenzwerte der Energiespeicherracks Referenzwerte der Ladezustände der Energiespeicherracks sind.

11. Verfahren zum Spannungsausgleich eines Energiespeichersystems, das einen Strang von in Reihe verbundenen Energiespeicherracks (101-103, 201-203) umfasst, die jeweils in Reihe verbundene Energiespeichermodule (104-106, 204, 205) umfassen, von denen jedes eine oder mehrere Energiespeicherzellen umfasst, die jeweils mit einer steuerbaren Entladeschaltung (107) zum Entladen der Energiespeicherzelle verbunden sind, wobei das Verfahren umfasst:
- Bestimmen (301) basierend auf Rackzustandswerten (V_{cr}_₁, ..., V_{cr}__{N}) der Energiespeicherracks, welches oder welche der Energiespeicherracks zu steuern sind, um den oder die entsprechenden der Rackzustandswerte zu ändern und ein Spannungsungleichgewicht zwischen den Energiespeicherracks zu reduzieren, wobei die Rackzustandswerte direkt proportional zu den Spannungen der Energiespeicherracks sind, und
- Bilden (302) eines Rackreferenzwerts (V_{ref}__{cr}_₁, ..., V_{ref}__{cr}__{N}) für mindestens jedes der Energiespeicherracks, die dazu bestimmt sind, gesteuert zu werden, um ihren Rackzustandswert zu ändern,
wobei das Verfahren für jedes der Energiespeicherracks umfasst:
- als Reaktion auf eine Situation, in der das Energiespeicherrack zu steuern ist, um seinen Rackzustandswert zu ändern, Bestimmen (303), basierend auf mindestens i) Modulzustandswerten (V_{ce}_₁, ..., V_{ce}__{M}) der Energiespeichermodule des Energiespeicherracks und ii) dem Rackreferenzwert (V_{ref}__{cr}_ᵢ) des Energiespeicherracks, welches oder welche dieser Energiespeichermodule zu steuern sind, um ein Spannungsungleichgewicht zwischen diesen Energiespeichermodulen zu reduzieren und den Rackzustandswert (V_{cr}_ᵢ) des Energiespeicherracks in Richtung des Rackreferenzwerts (V_{ref}__{cr}_ᵢ) des Energiespeicherracks anzusteuern, und andernfalls Bestimmen (304), basierend auf mindestens diesen Modulzustandswerten (V_{ce}_₁, ..., V_{ce}__{M}), welches oder welche der zu dem Energiespeicherrack gehörenden Energiespeichermodule zu steuern sind, um ein Spannungsungleichgewicht zwischen diesen Energiespeichermodulen zu reduzieren, und
- Steuern (305) der steuerbaren Entladeschaltungen, um die eine oder die mehreren Energiespeicherzellen zu entladen, die zu den ein oder mehreren der Energiespeichermodule gehören, die dazu bestimmt sind, gesteuert zu werden,
**dadurch gekennzeichnet, dass** das Verfahren für jedes der Energiespeicherracks, das zu steuern ist, um seinen Rackzustandswert zu ändern, das Bilden eines Offsets (V_{cr}__{off}_ᵢ) als fallende Funktion des Rackzustandswerts (V_{cr}_ᵢ) des Energiespeicherracks und für jedes der Energiespeicherracks, das zu steuern ist, um seinen Rackzustandswert zu ändern, das Bilden des Rackreferenzwerts (V_{ref}__{cr}_ᵢ) als Summe (V_{cr}__{off}_ᵢ + minV_{cr}) aus dem Offset und einem kleinsten der Rackzustandswerte der Energiespeicherracks umfasst.

12. Verfahren nach Anspruch 11, wobei jede der Energiespeicherzellen eine Kondensatorzelle oder eine Hybridenergiespeicherzelle ist.

13. Computerprogramm zum Spannungsausgleich eines Energiespeichersystems, das einen Strang von in Reihe verbundenen Energiespeicherracks (101-103, 201-203) umfasst, die jeweils in Reihe verbundene Energiespeichermodule (104-106, 204, 205) umfassen, von denen jedes eine oder mehrere Energiespeicherzellen umfasst, die jeweils mit einer steuerbaren Entladeschaltung (107) zum Entladen der Energiespeicherzelle verbunden sind, wobei das Computerprogramm computerausführbare Befehle zum Steuern eines programmierbaren Datenverarbeitungssystems umfasst zum:
- Bestimmen, basierend auf Rackzustandswerten (V_{cr}_₁, ..., V_{cr}__{N}) der Energiespeicherracks, welches oder welche der Energiespeicherracks zu steuern sind, um den oder die entsprechenden der Rackzustandswerte zu ändern und ein Spannungsungleichgewicht zwischen den Energiespeicherracks zu reduzieren, wobei die Rackzustandswerte direkt proportional zu Spannungen der Energiespeicherracks sind, und
- Bilden eines Rackreferenzwerts (V_{ref}__{cr}_₁, ..., V_{ref}__{cr}__{N}) für mindestens jedes der Energiespeicherracks, die dazu bestimmt sind, gesteuert zu werden, um ihren Rackzustandswert zu ändern,
wobei das Computerprogramm ferner computerausführbare Befehle zum Steuern des programmierbaren Datenverarbeitungssystems umfasst, um für jedes der Energiespeicherracks die folgenden Aktionen durchzuführen:
- als Reaktion auf eine Situation, in der das Energiespeicherrack zu steuern ist, um seinen Rackzustandswert zu ändern, Bestimmen, basierend auf mindestens i) Modulzustandswerten (V_{ce}_₁, ..., V_{ce}__{M}) der Energiespeichermodule des Energiespeicherracks und ii) dem Rackreferenzwert (V_{ref}__{cr}_ᵢ) des Energiespeicherracks, welches oder welche dieser Energiespeichermodule zu steuern sind, um ein Spannungsungleichgewicht zwischen diesen Energiespeichermodulen zu reduzieren und den Rackzustandswert (V_{ce}_ᵢ) des Energiespeicherracks in Richtung des Rackreferenzwerts (V_{ref}__{cr}_ᵢ) des Energiespeicherracks anzusteuern, und andernfalls Bestimmen, basierend auf mindestens diesen Modulzustandswerten (V_{ce}_₁, ..., V_{ce}__{M}), welches oder welche der zu dem Energiespeicherrack gehörenden Energiespeichermodule zu steuern sind, um ein Spannungsungleichgewicht zwischen diesen Energiespeichermodulen zu reduzieren, und
- Steuern der steuerbaren Entladeschaltungen, um die eine oder die mehreren Energiespeicherzellen zu entladen, die zu den ein oder mehreren der Energiespeichermodule gehören, die dazu bestimmt sind, gesteuert zu werden,
**dadurch gekennzeichnet, dass** das Computerprogramm computerausführbare Befehle umfasst zum Steuern des programmierbaren Datenverarbeitungssystems zum Bilden eines Offsets (V_{cr}__{off}_ᵢ) als fallende Funktion des Rackzustandswerts (V_{cr}_ᵢ) des Energiespeicherracks für jedes der Energiespeicherracks, das zu steuern ist, um seinen Rackzustandswert zu ändern, und Bilden des Rackreferenzwerts (V_{ref}__{cr}_ᵢ) als Summe (V_{cr}__{off}_ᵢ + minV_{cr}) aus dem Offset und einem kleinsten der Rackzustandswerte der Energiespeicherracks für jedes der Energiespeicherracks, das zu steuern ist, um seinen Rackzustandswert zu ändern.

## Revendications

1. Système de pilotage pour l'équilibrage de tension d'un système de stockage d'énergie qui comprend une chaîne de baies de stockage d'énergie (101-103, 201-203) connectées en série, comprenant chacune des modules de stockage d'énergie (104-106, 204, 205) connectés en série, comprenant chacun une ou plusieurs cellules de stockage d'énergie, étant chacune connectée à un circuit de décharge pilotable (107) pour décharger la cellule de stockage d'énergie, le système comprenant un système de traitement de données (108, 208) configuré pour :
- déterminer, sur la base de valeurs d'état de baie (_{Vcr_1}, ..., V_{cr_N}) des baies de stockage d'énergie, laquelle ou lesquelles des baies de stockage d'énergie doit/doivent être pilotées pour modifier une ou plusieurs des valeurs d'état de baie respectives afin de réduire le déséquilibre de tension entre les baies de stockage d'énergie, les valeurs d'état de baie étant directement proportionnelles aux tensions des baies de stockage d'énergie et
- former une valeur de référence de baie (V_{ref_cr_1}, ..., V_{ref_cr_N}) pour au moins chacune des baies de stockage d'énergie déterminées comme devant être pilotées pour modifier sa valeur d'état de baie,
dans lequel le système de traitement de données est configuré pour effectuer les actions suivantes pour chacune des baies de stockage d'énergie :
- en réponse à une situation dans laquelle la baie de stockage d'énergie doit être pilotée pour modifier sa valeur d'état de baie, déterminer, sur la base d'au moins i) des valeurs d'état de module (V_{ce_1}, ..., V_{ce_M}) des modules de stockage d'énergie de la baie de stockage d'énergie et ii) la valeur de référence de baie (V_{ref_cr_i}) de la baie de stockage d'énergie, lequel ou lesquels de ces modules de stockage d'énergie doit/doivent être pilotés pour réduire le déséquilibre de tension entre ces modules de stockage d'énergie et pour amener la valeur d'état de baie (V_{ce_i}) de la baie de stockage d'énergie vers la valeur de référence de baie (V_{ref_cr_i}) de la baie de stockage d'énergie, et sinon déterminer, sur la base d'au moins ces valeurs d'état de module (V_{ce_1}, ..., V_{ce_M}), lequel ou lesquels des modules de stockage d'énergie appartenant à la baie de stockage d'énergie doit/doivent être pilotés pour réduire le déséquilibre de tension entre ces modules de stockage d'énergie et
- piloter les circuits de décharge pilotables pour décharger une ou plusieurs cellules de stockage d'énergie appartenant à un ou plusieurs des modules de stockage d'énergie déterminés comme devant être pilotés,
**caractérisé en ce que** le système de traitement de données est configuré pour former, pour chacune des baies de stockage d'énergie devant être pilotées pour modifier sa valeur d'état de baie, un décalage (V_{cr_off_i}) en tant que fonction décroissante de la valeur d'état de baie (V_{cr_i}) de la baie de stockage d'énergie et pour former, pour chacune des baies de stockage d'énergie devant être pilotés pour modifier sa valeur d'état de baie, la valeur de référence de baie (V_{ref_cr_i}) en tant que somme (V_{cr_off_i} + minV_{cr}) du décalage et de la plus petite des valeurs d'état de baie des baies de stockage d'énergie.

2. Système de pilotage selon la revendication 1, dans lequel le système de traitement de données est configuré pour calculer, pour chacune des baies de stockage d'énergie, un coefficient d'équilibrage de chaîne selon une formule suivante : ${C}_{bs_i} = \left({S}_{cr_i}-{minS}_{cr}\right) / \left({maxS}_{cr}-{minS}_{cr}\right) ,$ où C_{bs_i} est le coefficient d'équilibrage de chaîne de la i^{ième} baie de stockage d'énergie, S_{cr_i} est la valeur d'état de baie de la i^{ième} baie de stockage d'énergie, minS_{cr} est la plus petite des valeurs d'état de baie des baies de stockage d'énergie et maxS_{cr} est la plus grande des valeurs d'état de baie des baies de stockage d'énergie et le système de traitement de données est configuré pour déterminer, parmi les baies de stockage d'énergie, celles dont le coefficient d'équilibrage de chaîne dépasse une première limite prédéterminée, comme devant être pilotées pour modifier leur valeur d'état de baie.

3. Système de pilotage selon la revendication 1 ou 2, dans lequel le système de traitement de données est configuré pour déterminer, parmi les baies de stockage d'énergie, celles dont la valeur d'état de baie dépasse une valeur minimale d'équilibrage prédéterminée, comme devant être pilotées pour modifier leur valeur d'état de baie.

4. Système de pilotage selon une quelconque des revendications 1 à 3, dans lequel les valeurs d'état de baie des baies de stockage d'énergie sont des tensions (V_{cr_1}, ..., V_{cr_N}) des baies de stockage d'énergie et les valeurs de référence de baie des baies de stockage d'énergie sont des valeurs de référence (V_{ref_cr_1}, ..., V_{ref_cr_N}) des tensions (V_{cr_1}, ..., V_{cr_N}) des baies de stockage d'énergie.

5. Système de pilotage selon une quelconque des revendications 1 à 3, dans lequel les valeurs d'état de baie des baies de stockage d'énergie sont des valeurs d'état de charge des baies de stockage d'énergie et les valeurs de référence de baie des baies de stockage d'énergie sont des valeurs de référence des états de charge des baies de stockage d'énergie.

6. Système de pilotage selon une quelconque des revendications 1 à 5, dans lequel le système de traitement de données est configuré pour former les valeurs de référence de baie pour toutes les baies de stockage d'énergie de telle sorte que la valeur de référence de baie présente une valeur d'indicateur prédéterminée en réponse à une situation dans laquelle la baie de stockage d'énergie concernée ne doit pas être pilotée pour modifier sa valeur d'état de baie.

7. Système de pilotage selon une quelconque des revendications 1 à 6, dans lequel le système de traitement de données est configuré pour calculer informatiquement, pour chacun des modules de stockage d'énergie de chacune des baies de stockage d'énergie devant être pilotées pour modifier sa valeur d'état de module, un coefficient d'équilibrage selon une formule suivante : ${C}_{bal_j} = \left({S}_{ce_j}+\left({S}_{cr_i}-{R}_{ref_i}\right)/M-{S}_{ce_min_i}\right) / \left(\begin{matrix}{S}_{ce_max_i} - \\ {S}_{ce_min_i}\end{matrix}\right) ,$ où C_{bal_j} est le coefficient d'équilibrage du j^{ième} module de stockage d'énergie de la i^{ième} baie de stockage d'énergie, S_{ce_j} est la valeur d'état de module du j^{ième} module de stockage d'énergie de la i^{ième} baie de stockage d'énergie, R_{ref_i} est la valeur de référence de baie du i^{ième} baie de stockage d'énergie, S_{cr_i} est la valeur d'état de baie de la i^{ième} baie de stockage d'énergie, M est le nombre de modules de stockage d'énergie connectés en série de la i^{ième} baie de stockage d'énergie, S_{ce_min_i} est la plus petite des valeurs d'état de module dans le i^{ième} baie de stockage d'énergie et S_{ce_max_i} est la plus grande des valeurs d'état de module dans le i^{ième} baie de stockage d'énergie et le système de traitement de données est configuré pour déterminer que chacun des modules de stockage d'énergie dont le coefficient d'équilibrage est supérieur à une limite prédéterminée doit être piloté au moyen d'un ou plusieurs circuits de décharge pilotables respectifs.

8. Système de pilotage selon une quelconque des revendications 1 à 6, dans lequel le système de traitement de données est configuré pour calculer informatiquement, pour chacun des modules de stockage d'énergie de chacune des baies de stockage d'énergie devant être pilotées pour modifier sa valeur d'état de baie, une valeur d'état de module mise à jour selon une formule suivante : ${S}_{new_cej} = {S}_{ce_i} + \left({R}_{ref_i}-{S}_{cr_i}\right) / M ,$ où S_{new_cej} est la valeur d'état de module mise à jour du j^{ième} module de stockage d'énergie de la i^{ième} baie de stockage d'énergie, S_{ce_i} est la valeur d'état de module du j^{ième} module de stockage d'énergie, R_{ref_i} est la valeur de référence de baie de la i^{ième} baie de stockage d'énergie, S_{cr_i} est la valeur d'état de baie de la i^{ième} baie de stockage d'énergie et M est le nombre de modules de stockage d'énergie connectés en série de la i^{ième} baie de stockage d'énergie et le système de traitement de données est configuré pour déterminer que chacun des modules de stockage d'énergie, dont la valeur d'état de module mise à jour dépasse une moyenne arithmétique des valeurs d'état de module mises à jour d'une marge prédéterminée, doit être piloté au moyen d'un ou plusieurs circuits de décharge pilotables respectifs.

9. Système de pilotage selon une quelconque des revendications 1 à 8, dans lequel les valeurs d'état de module des modules de stockage d'énergie sont des tensions (V_{ce_1}, ..., V_{ce_M}) des modules de stockage d'énergie et les valeurs de référence de baie des baies de stockage d'énergie sont des valeurs de référence (V_{ref_cr_1}, ..., V_{ref_cr_N}) des tensions (V_{cr_1}, ..., V_{cr_N}) des baies de stockage d'énergie.

10. Système de pilotage selon une quelconque des revendications 1 à 9, dans lequel les valeurs d'état des modules de stockage d'énergie comprennent des valeurs d'état de charge des modules de stockage d'énergie et les valeurs de référence de baie des baies de stockage d'énergie sont des valeurs de référence des états de charge des baies de stockage d'énergie.

11. Procédé d'équilibrage de tension d'un système de stockage d'énergie comprenant une chaîne de baies de stockage d'énergie (101-103, 201-203) connectées en série, chaque baie comprenant des modules de stockage d'énergie (104-106, 204, 205) connectés en série, comprenant chacun une ou plusieurs cellules de stockage d'énergie étant chacune connectées à un circuit de décharge pilotable (107) pour décharger la cellule de stockage d'énergie, le procédé comprenant :
- la détermination (301), sur la base de valeurs d'état de baie (V_{cr_1}, ..., V_{cr_N}) des baies de stockage d'énergie, de laquelle ou desquelles baies de stockage d'énergie doit/doivent être pilotées pour modifier une ou plusieurs des valeurs d'état de baie respectives afin de réduire le déséquilibre de tension entre les baies de stockage d'énergie, les valeurs d'état de baie étant directement proportionnelles aux tensions des baies de stockage d'énergie et
- la formation (302) d'une valeur de référence de baie (V_{ref_cr_1}, ..., V_{ref_cr_N}) pour au moins chacune des baies de stockage d'énergie déterminées comme devant être pilotées pour modifier sa valeur d'état de baie,
dans lequel le procédé comprend, pour chacune des baies de stockage d'énergie :
- en réponse à une situation dans laquelle la baie de stockage d'énergie doit être pilotée pour modifier sa valeur d'état de baie, la détermination (303), sur la base d'au moins i) des valeurs d'état de module (V_{ce_1}, ...., V_{ce_M}) des modules de stockage d'énergie de la baie de stockage d'énergie et ii) de la valeur de référence de baie (V_{ref_cr_i}) de la baie de stockage d'énergie, duquel ou desquels modules de stockage d'énergie doit/doivent être pilotés pour réduire le déséquilibre de tension entre ces modules de stockage d'énergie et amener la valeur d'état de baie (V_{cr_i}) de la baie de stockage d'énergie vers la valeur de référence de baie (V_{ref_cr_i}) de la baie de stockage d'énergie et sinon, la détermination (304), sur la base d'au moins ces valeurs d'état de module (V_{ce_1}, ..., V_{ce_M}), duquel ou desquels des modules de stockage d'énergie appartenant à la baie de stockage d'énergie doivent être pilotés pour réduire le déséquilibre de tension entre ces modules de stockage d'énergie et
- le pilotage (305) des circuits de décharge pilotables pour décharger une ou plusieurs cellules de stockage d'énergie appartenant à un ou plusieurs des modules de stockage d'énergie devant être pilotés,
**caractérisé en ce que** le procédé comprend la formation, pour chacune des baies de stockage d'énergie devant être pilotées pour modifier sa valeur d'état de baie, d'un décalage (V_{cr_off_i}) en tant que fonction décroissante de la valeur d'état de baie (V_{cr_i}) de la baie de stockage d'énergie et la formation, pour chacune des baies de stockage d'énergie devant être pilotées pour modifier sa valeur d'état de baie, de la valeur de référence de baie (V_{ref_cr_i}) en tant que somme (V_{cr_off_i} + minV_{cr}) du décalage et de la plus petite des valeurs d'état de baie des baies de stockage d'énergie.

12. Procédé selon la revendication 11, dans lequel chacune des cellules de stockage d'énergie est une cellule de condensateur ou une cellule de stockage d'énergie hybride.

13. Programme informatique pour l'équilibrage de tension d'un système de stockage d'énergie comprenant une chaîne de baies de stockage d'énergie (101-103, 201-203) connectées en série, comprenant chacune des modules de stockage d'énergie (104-106, 204, 205) connectés en série, comprenant chacun une ou plusieurs cellules de stockage d'énergie étant chacune connectée à un circuit de décharge pilotable (107) pour décharger la cellule de stockage d'énergie, le programme informatique comprenant des instructions exécutables par ordinateur pour piloter un système de traitement de données programmable afin de :
- déterminer, sur la base de valeurs d'état de baie (V_{cr_1}, ..., V_{cr_N}) des baies de stockage d'énergie, laquelle ou lesquelles des baies de stockage d'énergie doit/doivent être pilotées pour modifier une ou plusieurs des valeurs d'état de baie respectives afin de réduire le déséquilibre de tension entre les baies de stockage d'énergie, les valeurs d'état de baie étant directement proportionnelles aux tensions des baies de stockage d'énergie et
- former une valeur de référence de baie (V_{ref_cr_1}, ..., V_{ref_cr_N}) pour au moins chacune des baies de stockage d'énergie déterminées comme devant être pilotées pour modifier sa valeur d'état de baie,
dans lequel le programme informatique comprend en outre des instructions exécutables par ordinateur pour piloter le système de traitement de données programmable afin d'effectuer les actions suivantes pour chacune des baies de stockage d'énergie :
- en réponse à une situation dans laquelle la baie de stockage d'énergie doit être pilotée pour modifier sa valeur d'état de baie, déterminer, sur la base d'au moins i) des valeurs d'état de module (V_{ce_1}, ..., V_{ce_M}) des modules de stockage d'énergie de la baie de stockage d'énergie et ii) la valeur de référence de baie (V_{ref_cr_i}) de la baie de stockage d'énergie, lequel ou lesquels de ces modules de stockage d'énergie doit/doivent être pilotés pour réduire le déséquilibre de tension entre ces modules de stockage d'énergie et amener la valeur d'état de baie (V_{ce_i}) de la baie de stockage d'énergie vers la valeur de référence de baie (V_{ref_cr_i}) de la baie de stockage d'énergie, et sinon déterminer, sur la base d'au moins ces valeurs d'état de module (V_{ce_1}, ..., V_{ce_M}), lequel ou lesquels des modules de stockage d'énergie appartenant à la baie de stockage d'énergie doit/doivent être pilotés pour réduire le déséquilibre de tension entre ces modules de stockage d'énergie et
- piloter les circuits de décharge pilotables pour décharger une ou plusieurs cellules de stockage d'énergie appartenant à un ou plusieurs des modules de stockage d'énergie déterminés comme devant être pilotés,
**caractérisé en ce que** le programme d'ordinateur comprend des instructions exécutables par ordinateur pour piloter le système de traitement de données programmable afin de former, pour chacune des baies de stockage d'énergie devant être pilotées pour modifier sa valeur d'état de baie, un décalage (V_{cr_off_i}) en tant que fonction décroissante de la valeur d'état de baie (V_{cr_i}) de la baie de stockage d'énergie et de former, pour chacune des baies de stockage d'énergie devant être pilotées pour modifier sa valeur d'état de baie, la valeur de référence de baie (V_{ref_cr_i}) en tant que somme (V_{cr_off_i} + minV_{cr}) du décalage et de la plus petite des valeurs d'état de baie des baies de stockage d'énergie.
